# EUROPEAN PATENT APPLICATION

(11) **EP 4 766 119 A1**
(43) Date of publication of application: **24.06.2026**
(21) Application number: 23962753.2
(22) Date of filing: 29.12.2023
(51) Int. Cl.: H10K 59/32

(54) **DISPLAY SUBSTRATE AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHAO, Erjin, Beijing 100176 (CN); JIANG, Zhiliang, Beijing 100176 (CN); HU, Ming, Beijing 100176 (CN); QIU, Haijun, Beijing 100176 (CN); YU, Ziyang, Beijing 100176 (CN); WU, Jianpeng, Beijing 100176 (CN); ZHANG, Tiaomei, Beijing 100176 (CN); WANG, Mengqi, Beijing 100176 (CN); DONG, Xiangdan, Beijing 100176 (CN); LIU, Tingliang, Beijing 100176 (CN); FAN, Cong, Beijing 100176 (CN); ZHANG, Yi, Beijing 100176 (CN); XIE, Taofeng, Beijing 100176 (CN)
(74) Representative: Brötz, Helmut
(86) International application number: PCT/CN2023/143095
(87) International publication number: WO 2025/138074

(57) **Abstract**

A display substrate and a display device. The display substrate comprises sub-pixels, pixel defining patterns, and defining structures. The sub-pixels each comprise a light-emitting functional layer; the pixel defining patterns each comprise openings and pixel defining portions surrounding the openings, and at least part of each light-emitting functional layer is isolated in at least one opening; and the defining structures are located between the pixel defining portions and a base substrate. The defining structures each are located between two corresponding adjacent sub-pixels of different colors; the defining structures each comprise a first portion covered by the corresponding pixel defining portion and a second portion exposed out of the corresponding opening; the second portions of the defining structures are configured to isolate the light-emitting functional layers; and the defining structures are made of an organic material, and the orthographic projection of the edge of the side surface of each second portion distant from one side of the base substrate on the base substrate falls within the orthographic projection of the corresponding opening on the base substrate, such that the corresponding light-emitting functional layer is isolated to reduce crosstalk, thereby minimizing the effect of the defining structures on the process and productivity while guaranteeing the electrode flatness and normal light-emitting effects of the sub-pixels.

## Description

### TECHNICAL FIELD

The present disclosure relates to a display substrate and a display device.

### BACKGROUND

The organic light-emitting diode (OLED) display device is favored by users because of rich colors, fast response time, and foldability. At present, when using display devices with organic light-emitting diodes, such as mobile phones, users desire longer standby time and service life as much as possible, which puts forward higher requirements for the screen design. An organic light-emitting display device with a tandem structure improves the life and brightness of a light-emitting device by adding at least one light-emitting layer and a charge-generating layer in the organic light-emitting device, and reduces the power consumption to meet the demand of users for the power consumption and service life of the display devices.

### SUMMARY

The embodiments of the present disclosure provide a display substrate and a display device.

An embodiment of the present disclosure provides a display substrate, which includes: a base substrate and a plurality of sub-pixels, a pixel-defining pattern and a defining structure located on the base substrate. Each sub-pixel in at least part of the sub-pixels includes a light-emitting functional layer, and the light-emitting functional layer includes a plurality of film layers; the pixel-defining pattern located on the base substrate, wherein the pixel-defining pattern includes a plurality of openings and a pixel-defining portion surrounding the plurality of openings, and at least part of at least one layer of the light-emitting functional layer is isolated in at least one of the openings; the defining structure is located between the pixel-defining portion and the base substrate. The defining structure is at least located between two adjacent sub-pixels of different colors, and the defining structure includes a first portion covered by the pixel-defining portion and a second portion exposed by the opening, and the second portion of the defining structure is configured to isolate the at least one layer of the light-emitting functional layer; a material of the defining structure includes an organic material, and an orthographic projection of an edge of, a side surface of the second portion of the defining structure, away from the base substrate on the base substrate falls into an orthographic projection of the opening on the base substrate.

For example, according to an embodiment of the present disclosure, the plurality of openings includes a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one of the second openings is isolated; the second portion of the defining structure is exposed by at least one kind of the first opening and the second opening.

For example, according to an embodiment of the present disclosure, a thickness of the defining structure is not greater than 5 microns, and a surface edge of a side of the second portion of the defining structure away from the base substrate protrudes relative to a surface edge of a side of the second portion of the defining structure close to the base substrate by a size not greater than 5 microns.

For example, according to an embodiment of the present disclosure, an angle between a side surface of the second portion of the defining structure and a plane where a first surface of the defining structure close to the base substrate is located is greater than 20 degrees and less than 90 degrees; an orthographic projection of the first surface on the base substrate falls into an orthographic projection, of a second surface of the second portion away from the base substrate, on the base substrate, and a distance between an orthographic projection of an edge of the first surface and an orthographic projection of an edge of the second surface is not greater than 5 microns.

For example, according to an embodiment of the present disclosure, each sub-pixel in the at least part of the sub-pixels further includes a first electrode and a second electrode located on both sides of the light-emitting functional layer, and the first electrode is located between the light-emitting functional layer and the base substrate; a thickness of the defining structure is greater than that of the first electrode, and a thickness of at least part of the pixel-defining portion that does not overlap with the defining structure in a direction perpendicular to the base substrate is greater than the thickness of the defining structure.

For example, according to an embodiment of the present disclosure, the defining structure covers an edge of the first electrode.

For example, according to an embodiment of the present disclosure, the plurality of openings includes a plurality of first openings, the plurality of first openings is configured to define light-emitting regions of the at least part of the sub-pixels, and at least part of the at least one layer of the light-emitting functional layer in the first opening is a continuous part, and the second portion of the defining structure is at least exposed by the first opening.

For example, according to an embodiment of the present disclosure, the plurality of openings includes a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated; an orthographic projection of the defining structure on the base substrate does not overlap with an orthographic projection of the first opening on the base substrate, and the second opening exposes the second portion of the defining structure.

For example, according to an embodiment of the present disclosure, a size of a part, of the defining structure, covering the first electrode is not greater than 5 microns in a direction of arrangement of the two adjacent sub-pixels of different colors.

For example, according to an embodiment of the present disclosure, each sub-pixel in the at least part of the sub-pixels further includes a first electrode and a second electrode located on both sides of the light-emitting functional layer, and the first electrode is located between the light-emitting functional layer and the base substrate; an insulating layer is disposed between the first electrode and the base substrate, both the first electrode and the defining structure are in contact with a surface of the insulating layer, the defining structure and the first electrode are spaced apart, and a distance between the defining structure and the first electrode which is closest to the defining structure is not greater than 10 microns.

For example, according to an embodiment of the present disclosure, the display substrate further includes: a photo spacer located at a side of the pixel-defining portion away from the base substrate. A material of the defining structure is different from a material of the photo spacer.

For example, according to an embodiment of the present disclosure, a thickness of the photo spacer is not greater than 5 microns, and a thickness of the pixel-defining portion is not greater than 5 microns.

For example, according to an embodiment of the present disclosure, an orthographic projection of the photo spacer on the base substrate overlaps with an orthographic projection of the defining structure on the base substrate; or an orthographic projection of the photo spacer on the base substrate does not overlap with an orthographic projection of the defining structure on the base substrate.

For example, according to an embodiment of the present disclosure, a part of the defining structure between the two adjacent sub-pixels of different colors includes at least one sub-defining structure.

For example, according to an embodiment of the present disclosure, the adjacent two sub-pixels of different colors include a first color sub-pixel and a second color sub-pixel, the at least one sub-defining structure includes one sub-defining structure, and an edge of a first portion of the sub-defining structure is closer to an edge of the light-emitting region of the first color sub-pixel.

For example, according to an embodiment of the present disclosure, the first color sub-pixel includes a red sub-pixel or a green sub-pixel, and the second color sub-pixel includes a blue sub-pixel.

For example, according to an embodiment of the present disclosure, the plurality of openings includes a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated; the at least one sub-defining structure includes two sub-defining structures that are spaced apart from each other, a second portion of one of the two sub-defining structures is exposed by the first opening, and a second portion of the other of the two sub-defining structures is exposed by the second opening.

For example, according to an embodiment of the present disclosure, the at least one sub-defining structure includes two sub-defining structures that are spaced apart, and edges of the two sub-defining structures that are opposite to each other are exposed by the same opening.

For example, according to an embodiment of the present disclosure, the plurality of openings includes a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated; the at least one sub-defining structure includes one sub-defining structure, a side edge of the one sub-defining structure is exposed by the first opening, and another side edge of the one sub-defining structure is exposed by the second opening.

For example, according to an embodiment of the present disclosure, the at least one sub-defining structure includes an annular sub-defining structure surrounding the light-emitting region of at least one sub-pixel.

For example, according to an embodiment of the present disclosure, the two sub-defining structures are respectively two annular sub-defining structures surrounding light-emitting regions of the two adjacent sub-pixels of different colors.

For example, according to an embodiment of the present disclosure, the first electrode of each sub-pixel includes a main electrode and a connecting electrode, and the main electrode overlaps with the light emitting region of the sub-pixel and has a similar shape; an orthographic projection of the connecting electrode of at least one sub-pixel on the base substrate does not overlap with orthographic projections of the defining structure and the opening on the base substrate.

For example, according to an embodiment of the present disclosure, the plurality of openings includes a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated; the defining structure includes a plurality of defining portions and a connecting portion connecting at least a part of the plurality of defining portions, in a direction perpendicular to the base substrate, the defining portion overlaps with the second opening, and an orthographic projection of the connecting portion on the base substrate completely falls into an orthographic projection of the pixel-defining portion on the base substrate; and an orthographic projection of the photo spacer on the base substrate completely falls into an orthographic projection of the connecting portion on the base substrate.

For example, according to an embodiment of the present disclosure, at least one second opening is shaped as a strip, and the at least one second opening is located between the two adjacent sub-pixels of different colors, and a long side of the strip is perpendicular to an arrangement direction of the two adjacent sub-pixels of different colors.

For example, according to an embodiment of the present disclosure, the long edge of the strip is parallel to an edge of the first opening closest to the strip.

For example, according to an embodiment of the present disclosure, in an extension direction of the sub-defining structure, a length of the opening overlapping with the sub-defining structure is greater than or less than a length of the sub-defining structure.

Another embodiment of the present disclosure provides a display substrate which includes: a base substrate, and a plurality of sub-pixels, a pixel-defining pattern and a defining structure located on the base substrate. Each sub-pixel in at least part of the sub-pixels includes a light-emitting functional layer, and the light-emitting functional layer includes a plurality of film layers; the pixel-defining pattern includes a plurality of first openings, a plurality of second openings and a pixel-defining portion surrounding the plurality of first openings and the plurality of second openings, the plurality of first openings is configured to define light-emitting regions of the at least part of the sub-pixels, and at least part of at least one layer of the light-emitting functional layer in the first opening is a continuous part, and at least a part of the at least one layer of the light-emitting functional layer in at least one of the second openings is isolated. The defining structure is at least located between two adjacent sub-pixels of different colors, and the defining structure includes a first portion covering a surface of the pixel-defining portion away from the base substrate and a second portion located in the second opening, and the second portion of the defining structure is configured to isolate at least one layer of the light-emitting functional layer; a material of the defining structure includes an organic material, and a surface edge of a side of the second portion of the defining structure away from the base substrate protrudes relative to a surface edge of a side of the second portion of the defining structure close to the base substrate.

For example, according to an embodiment of the present disclosure, a surface edge of a side of the first portion of the defining structure close to the base substrate protrudes from a surface edge of a side of the first portion of the defining structure away from the base substrate, and a thickness of the first portion is less than a thickness at least some positions of the second portion.

Another embodiment of the present disclosure provides a display device, including any display substrate as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1 is a schematic diagram of a partial planar structure provided according to an example of an embodiment of the present disclosure.
Fig. 2 is a schematic diagram of a partial cross-sectional structure taken along the AA' line shown in Fig. 1.
Fig. 3 is a partial enlarged view of the display substrate shown in Fig. 1.
Fig. 4 is a schematic diagram of a partial planar structure of a display substrate provided according to another example of an embodiment of the present disclosure.
Fig. 5 is a schematic diagram of a partial cross-sectional structure of a display substrate provided according to another example of an embodiment of the present disclosure.
Fig. 6 and Fig. 7 are schematic diagrams of partial cross-sectional structures of a display substrate provided according to different examples of an embodiment of the present disclosure.
Fig. 8 is a schematic diagram of a partial planar structure of a display substrate provided according to another example of an embodiment of the present disclosure.
Fig. 9 is a schematic diagram of a partial cross-sectional structure taken along the CC' line shown in Fig. 8.
Fig. 10 is a schematic diagram of a partial cross-sectional structure of a display substrate provided according to another example of an embodiment of the present disclosure.
Fig. 11 is a schematic diagram of a partial planar structure of a display substrate provided according to another example of an embodiment of the present disclosure.
Fig. 12 is a schematic diagram of a partial cross-sectional structure taken along the DD' line shown in Fig. 11.
Fig. 13 and Fig. 14 are schematic diagrams of partial planar structures of a display substrate provided according to different examples of an embodiment of the present disclosure.
Fig. 15 is a schematic diagram of a partial cross-sectional structure taken along the EE' line shown in Fig. 13.
Fig. 16 is a schematic diagram of a partial cross-sectional structure taken along the FF' line shown in Fig. 14.
Fig. 17 is a schematic diagram of a partial planar structure of the display substrate provided according to another example of an embodiment of the present disclosure.
Fig. 18 is a partial enlarged view of the display substrate shown in Fig. 17.
Fig. 19 is a schematic diagram of a partial cross-sectional structure of a display substrate provided according to another embodiment of the present disclosure.
Fig. 20 is a schematic block diagram of a display device provided according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "approximately the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two.

The Tandem technology is to stack and connect in series the sub-pixel light-emitting layers, and provide a whole charge-generating layer between the stacked light-emitting layers, such as a P-type doped charge-generating layer P-CGL and an N-type doped charge-generating layer N-CGL. Compared with the display substrate without the Tandem device, the Tandem device uses an N/P-CGL as a heterojunction to connect two light-emitting layers in series. This technology in order connects in series two light-emitting devices, and under the same luminous intensity, greatly reduces the luminous current of light-emitting devices, improves the life of organic light-emitting devices, and reduces power consumption.

During the research, the inventor of the present application found that on the one hand, the Tandem device adopts stacked light-emitting layers, which puts forward higher requirements for materials and evaporation; and on the other hand, because of the high conductivity of the charge-generating layer in the Tandem device, for example, when the charge-generating layer is a whole surface film layer, the charge-generating layer of adjacent two sub-pixels is a continuous film and may have a phenomenon of charge transverse migration, which leads to low-grayscale monochromatic chromaticity shift of the display substrate, such as crosstalk between adjacent sub-pixels, resulting in the color shift of the display substrate. For example, the charge-generating layer may easily lead to crosstalk between sub-pixels of different colors at low brightness, which further leads to low-grayscale color shift.

Embodiments of the present disclosure provide a display substrate and a display device. The display substrate includes a base substrate, a plurality of sub-pixels, a pixel-defining pattern, and a defining structure located on the base substrate. Each sub-pixel in at least some of the sub-pixels includes a light-emitting functional layer, and the light-emitting functional layer includes a plurality of film layers. The pixel-defining pattern includes a plurality of openings and a pixel-defining portion surrounding the plurality of openings, and at least part of at least one layer of the light-emitting functional layer is isolated in at least one opening; the defining structure is located between the pixel-defining portion and the base substrate. The defining structure is located between the pixel-defining portion and the base substrate. The defining structure is at least located between two adjacent sub-pixels of different colors, and the defining structure includes a first portion covered by the pixel-defining portion and a second portion exposed by the opening, and the second portion of the defining structure is configured to isolate the at least one layer of the light-emitting functional layer. A material of the defining structure includes an organic material, and an orthographic projection of an edge of, a side surface of the second portion of the defining structure, away from the base substrate on the base substrate falls into an orthographic projection of the opening on the base substrate.

The first portion of the defining structure made of the organic material provided in the present disclosure is covered by the pixel-defining portion, and the second portion is exposed by at least one opening, and at the same time, the orthographic projection of the edge of, the side surface of the second portion of the defining structure, away from the base substrate on the base substrate falls into the orthographic projection of the opening on the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structure on the process and throughput.

The display substrate and display device provided in the embodiments of the present disclosure are described below with reference to the accompanying drawings.

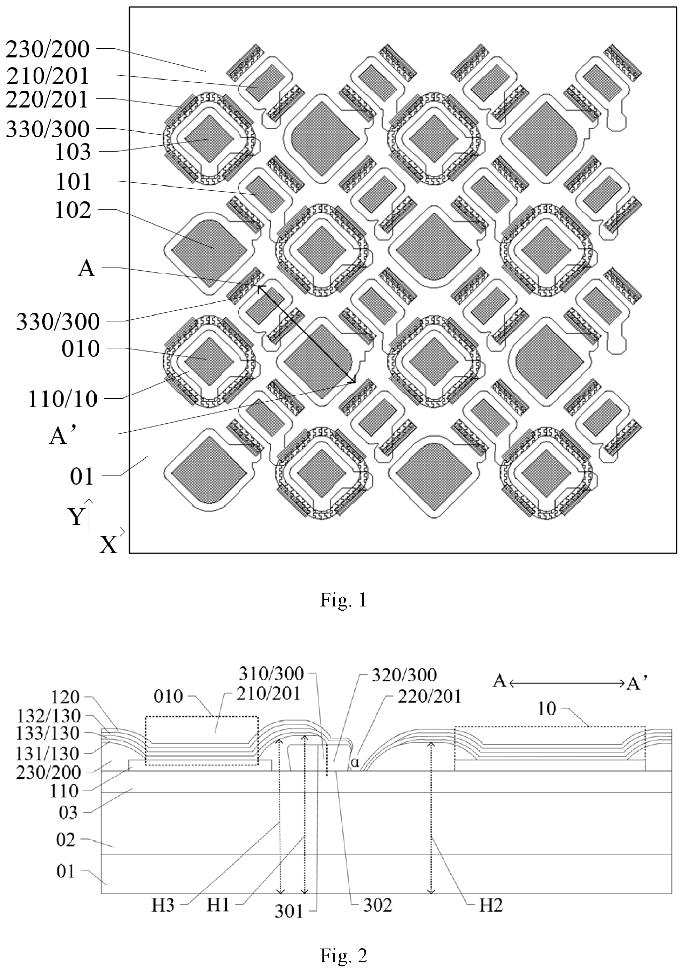

Fig. 1 is a schematic diagram of a partial planar structure provided according to an example of an embodiment of the present disclosure. Fig. 2 is a schematic diagram of a partial cross-sectional structure taken along the AA' line shown in Fig. 1.

As shown in Fig. 1 and Fig. 2, the display substrate includes a base substrate 01, a plurality of sub-pixels 10, a pixel-defining pattern 200 and a defining structure 300 located on the base substrate 01. Each sub-pixel 10 in at least part of the sub-pixels 10 includes a light-emitting functional layer 130, and the light-emitting functional layer 130 includes a plurality of film layers. For example, at least part of the sub-pixels 10 above is located in a display region of the display substrate, that is, a region used to display an image, and the display substrate further includes a peripheral region surrounding the display region.

For example, as shown in Fig. 2, the sub-pixel 10 further includes a first electrode 110 and a second electrode 120 located on both sides of the light-emitting functional layer 130 in a direction perpendicular to the base substrate 01 (for example, in a direction perpendicular to the direction of the XY plane as shown in Fig. 1), and the first electrode 110 is located between the light-emitting functional layer 130 and the base substrate 01.

For example, as shown in Fig. 2, the light-emitting functional layer 130 may include a light-emitting layer for emitting light as well as a charge-generating layer 133. For example, the light-emitting functional layer 130 may be a film in an organic light-emitting element. For example, the light-emitting functional layer 130 may include a first light-emitting layer (EML) 131, a charge-generating layer (CGL) 133 and a second light-emitting layer (EML) 132 arranged in a stacked manner, and the charge-generating layer 133 is located between the first light-emitting layer 131 and the second light-emitting layer 132. The thickness of the plurality of layers included in the light-emitting functional layer 130 shown in Fig. 2 is merely for a clear illustration of each layer and does not represent the actual size.

For example, as shown in Fig. 2, the charge-generating layer 133 has strong electrical conductivity, which provides the light-emitting functional layer 130 with advantages of long service life, low power consumption, and high brightness. For example, the same sub-pixel 10 may include a tandem light-emitting element, such as the Tandem OLED. Of course, the embodiments of the present disclosure are not limited thereto, and the light-emitting functional layer 130 of each sub-pixel 10 may also include only one light-emitting layer.

For example, as shown in Fig. 2, in the same sub-pixel 10, the first light-emitting layer 131 and the second light-emitting layer 132 can be light-emitting layers that emit light of the same color. For example, the first light-emitting layers 131 in sub-pixels 10 that emit light of different colors emit light of different colors. For example, the second light-emitting layers 132 in sub-pixels 10 that emit light of different colors emit light of different colors. Of course, the embodiments of the present disclosure are not limited thereto. For example, in the same sub-pixel 10, the first light-emitting layer 131 and the second light-emitting layer 132 can be light-emitting layers emitting different colors of light. Providing the light-emitting layers emitting light of different colors in the same sub-pixel 10 can mix the light emitted by the plurality of light-emitting layers included in the sub-pixel 10 into white light, and the color of the light emitted from each sub-pixel 10 can be adjusted by providing a color film layer.

For example, in each sub-pixel 10, the light-emitting functional layer 130 can also include a hole injection layer (HIL), a hole transport layer (HTL), an electron transport layer (ETL), and an electron injection layer (EIL).

For example, the hole injection layer, the hole transport layer, the electron transport layer, the electron injection layer, the charge-generating layer 133 and the second electrode 120 are all shared film layers of the plurality of sub-pixels 10, which can be called common layers.

For example, as shown in Fig. 2, the second light-emitting layer 132 can be located between the first light-emitting layer 131 and the second electrode 120, and the hole injection layer can be located between the first electrode 110 and the first light-emitting layer 131. For example, an electron transport layer can also be provided between the charge-generating layer 133 and the first light-emitting layer 131. For example, a hole transport layer may be provided between the second light-emitting layer 132 and the charge-generating layer 133. For example, an electron transport layer and an electron injection layer may be provided between the second light-emitting layer 132 and the second electrode 120.

For example, the charge-generating layer 133 may include an N-type charge-generating layer and a P-type charge-generating layer.

For example, the material of the electron transport layer may include aromatic heterocyclic compounds, e.g., imidazole derivatives such as benzimidazole derivatives, imidazopyridine derivatives, benzimidazole phenanthridine derivatives, etc.; zine derivatives such as pyrimidine derivatives, triazine derivatives, etc.; compounds containing a nitrogen-containing six-membered ring structure such as quinoline derivatives, isoquinoline derivatives, phenanthroline derivatives, etc. (compounds with phosphine oxide substituents on a heterocyclic ring are also included), or the like.

For example, the charge-generating layer 133 may be made of a material that is either a material containing a phosphorus group or a material containing triazine.

For example, the ratio of the electron mobility of the material of the charge-generating layer 133 to the electron mobility of the electron transport layer is 10⁻² to 10².

For example, the first electrode 110 may be an anode, and the second electrode 120 may be a cathode. For example, the cathode may be formed from a material with high conductivity and a low work function, for example, the cathode may be made of a metal material. For example, the anode may be formed from a transparent conductive material with a high work function.

For example, Fig. 2 schematically shows the spacing being provided between the light-emitting layers of different sub-pixels 10. For example, the area of the orthographic projection of the charge-generating layer 133 on the base substrate 01 is greater than the area of the orthographic projection of any light-emitting layer on the base substrate 01.

For example, as shown in Fig. 2, other structures 02 are further disposed on a side of the first electrode 110 facing the base substrate 01, such as a pixel circuit electrically connected with the first electrode 110 of the sub-pixel 10, a signal line and respective insulating layers, such as a passivation layer, a buffer layer, a gate insulating layer, an interlayer insulating layer, and the like.

As shown in Fig. 1 and Fig. 2, the pixel-defining pattern 200 includes a plurality of openings 201 and a pixel-defining portion 230 surrounding the plurality of openings 201, and at least part of at least one layer of the light-emitting functional layer 130 is isolated in the at least one of the openings 201.

In some examples, as shown in Fig. 1 and Fig. 2, the plurality of openings 201 includes a plurality of first openings 210 and a plurality of second openings 220, the plurality of first openings 210 is configured to define light-emitting regions 010 of at least part of the sub-pixels 10, and at least part of at least one layer of the light-emitting functional layer 130 in the first opening 210 is a continuous part, and at least a part of at least one layer of the light-emitting functional layer 130 in at least one of the second openings is partially isolated. As schematically shown in Fig. 1 and Fig. 2, a part of the film layer of the light functional layer 130 in the first opening 210 is a continuous portion, and the part in the second opening 220 is isolated.

For example, as shown in Fig. 1 and Fig. 2, one sub-pixel 10 corresponds to at least one first opening 210, at least part of the light-emitting functional layer 130 of the sub-pixel 10 is located in the first opening 210 corresponding to the sub-pixel 10, and the first opening 210 is configured to expose the first electrode 110. Fig. 1 shows only the light-emitting region 010 and the first electrode 110 of the sub-pixel, but does not show the second electrode 120, and the second electrode 120 can be a continuously arranged film at least outside the second opening 220.

For example, as shown in Fig. 2, when the light-emitting functional layer 130 is formed in the first opening 210 of the pixel-defining pattern 200, the first electrode 110 and the second electrode 120 located on both sides of the light-emitting functional layer 130 can drive the light-emitting functional layer 130 in the first opening 210 to emit light. For example, the first opening 210 of the pixel-defining pattern 200 is used to define the light-emitting region 010 of the sub-pixel 10. The light-emitting region 010 above may refer to the effective light-emitting region of the sub-pixel 10, and the shape of the light-emitting region 010 refers to a two-dimensional shape, for example, the shape of the light-emitting region 010 may be the same as the shape of the first opening 210 of the pixel-defining pattern 200.

For example, as shown in Fig. 2, the pixel-defining portion 230 may be made of materials including polyimide, acrylic, or polyethylene terephthalate, etc.

As shown in Fig. 1 and Fig. 2, the defining structure 300 is at least located between two adjacent sub-pixels 10 of different colors, and the defining structure 300 includes a first portion 310 covered by the pixel-defining portion 230 and a second portion 230 exposed by the opening 201, and the second portion 320 of the defining structure 300 is configured to isolate at least one layer of the light-emitting functional layer 130.

In some examples, as shown in Fig. 1 and Fig. 2, the defining structure 300 is located between the pixel-defining portion 230 and the base substrate 01, the defining structure 300 is at least located between two adjacent sub-pixels 10 of different colors, the defining structure 300 includes the first portion 310 covered by the pixel-defining portion 230 and the second portion 320 exposed by at least one of the first opening 210 and the second opening 220, and the second portion 320 of the defining structure 300 is configured to isolate at least one layer of the light-emitting functional layer 130, such as the charge-generating layer in the light-emitting functional layer 130, such as all the film layers in the light-emitting functional layer.

For example, as shown in Fig. 1 and Fig. 2, the orthographic projection of the first portion 310 of the defining structure 300 on the base substrate 01 overlaps with the orthographic projection of the pixel-defining portion 230 on the base substrate 01, and the orthographic projection of the second portion 320 of the defining structure 300 on the base substrate 01 does not overlap with the orthographic projection of the pixel-defining portion 230 on the base substrate 01. For example, the defining structure 300 includes two edges, one edge is an edge of the first portion 310, the other edge is an edge of the second portion 320, the edge of the first portion 310 is enclosed by the pixel-defining portion 230, and the edge of the second portion 320 is exposed by at least one of the first opening 210 and the second opening 220.

Fig. 1 and Fig. 2 schematically show that the second portion 320 of the defining structure 300 is exposed by the second opening 220 of the pixel-defining pattern 200. For example, as shown in Fig. 2, in the direction parallel to the base substrate 01, there is a certain gap between the edge of the defining structure 300 exposed by the second opening 220 and the pixel-defining portion 230, which includes a film layer which is isolated in the light-emitting functional layer 130.

As shown in Fig. 2, a material of the defining structure 300 includes an organic material, and an orthographic projection of an edge of, a side surface of the second portion 320 of the defining structure 300, away from the base substrate 01 on the base substrate 01 falls into an orthographic projection of the opening 201 on the base substrate 01.

For example, as shown in Fig. 2, an angle α between the side surface of the second portion 320 of the defining structure 300 and a plane where a surface of the defining structure 300 close to the base substrate 01 is located is greater than 20 degrees and less than 90 degrees. The angle between the side surface of the defining structure 300 and the plane above refers to an acute angle.

The first portion of the defining structure made of the organic material provided in the present disclosure is covered by the pixel-defining portion, and the second portion is exposed by at least one of the first opening and the second opening, and at the same time, the orthographic projection of the edge of, the side surface of the second portion of the defining structure, away from the base substrate on the base substrate falls into the orthographic projection of the opening on the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structure on the process and throughput.

Compared with the greater impact of the defining structure made of the inorganic material on the production capacity of the display substrate in the manufacturing process, the defining structure made of the organic material provided in the present disclosure can be formed after the first electrode of the sub-pixel, or in the case that the defining structure does not overlap with the first electrode of the sub-pixel, the defining structure is formed before the first electrode is formed, which will not affect the flatness of the first electrode, minimizing the impact on the process and production capacity. For example, the pixel-defining pattern is patterned after the first electrode and the defining structure are formed.

For example, as shown in Fig. 2, an angle α between a side surface of the second portion 320 of the defining structure 300 and a plane where a surface of the defining structure 300 away from the base substrate 01 is located is greater than 20 degrees and less than 90 degrees. For example, a connection between a side surface of the second portion 320 of the defining structure 300 and a surface of the defining structure 300 away from the base substrate 01 may be a round corner, and angle between the two surfaces may be α.

For example, as shown in Fig. 2, the angle α may be 30 degrees to 70 degrees. For example, the angle α may be 30 degrees to 60 degrees. For example, the angle α may be 25 degrees to 45 degrees. For example, the angle α may be 35 degrees to 60 degrees. For example, the angle α may be 45 degrees to 80 degrees. For example, the angle α may be 65 degrees to 80 degrees. For example, the angle α may be 71 degrees to 75 degrees.

For example, as shown in Fig. 1 and Fig. 2, the defining structure 300 may be made of a material of organic adhesive.

In some examples, as shown in Fig. 1 and Fig. 2, the cross-section of the defining structure 300 taken along the plane parallel to the arrangement direction of two adjacent sub-pixels 10 of different colors and perpendicular to the base substrate 01 is in a trapezoidal shape. For example, the above plane may be a plane parallel to a line AA' and perpendicular to a plane XY. For example, the above plane may be a plane perpendicular to the extension direction of the defining structure 300.

In some examples, as shown in Fig. 1 and Fig. 2, the length of a first base edge 301 of the trapezoid away from of the base substrate 01 is greater than the length of a second base edge 302 of the trapezoidal close to the base substrate 01. The angle between the first base edge 301 and the trapezoidal waist is greater than 20 degrees and less than 90 degrees, and the lengths of the first base edge 301 and the second base edge 302 are not greater than 10 microns.

Providing a defining structure of a structure with a trapezoidal cross-section may facilitate disconnecting at least one layer of the light-emitting functional layer and preventing crosstalk between two adjacent sub-pixels of different colors.

For example, as shown in Fig. 2, the lengths of the first base edge 301 and the second base edge 302 are not greater than 10 microns. For example, the lengths of the first base edge 301 and the second base edge 302 are not greater than 1 micron. For example, the lengths of the first base edge 301 and the second base edge 302 are not greater than 2 microns. For example, the length of the first base edge 301 is greater than 5 microns. For example, the length of the second base edge 302 is less than 8 microns. For example, the lengths of the first base edge 301 and the second base edge 302 are not greater than 3 microns. In the embodiments of the present disclosure, the first base edge 301 and the second base edge 302 may be any numerical value between greater than 0 and less than 10 microns, which will not be enumerated again herein.

In some examples, as shown in Fig. 2, the thickness of the defining structure 300 is not greater than 5 microns, and the edge of the surface of the second portion 320 of the defining structure 300 away from the base substrate 01 protrudes relative to the edge of the surface of the defining structure close to the base substrate 01 by a size not greater than 5 microns.

For example, as shown in Fig. 2, in the extension direction of the AA' line, the surface of the second portion 320 of the defining structure 300 away from the base substrate 01 protrudes relative to the surface of the second portion of the defining structure close to the base substrate 01 by a size not greater than 5 microns. For example, the surface of the second portion 320 of the defining structure 300 away from the base substrate 01 is the upper surface, and the surface of the second portion 320 of the defining structure 300 close to the base substrate 01 is the lower surface, and the edge of the upper surface may protrude relative to the edge of the lower surface by 1 micron, or 2 microns, or 3 microns, or 4 microns. The edge of the upper surface may protrude relative to the edge of the lower surface by any size of any numerical value between greater than 0 and less than 5 microns in the embodiments of the present disclosure, which will not be enumerated again herein.

In some examples, as shown in Fig. 2, the angle between a side surface of the second portion 320 of the defining structure 300 and the plane where the first surface of the defining structure 300 close to the base substrate 01 is located (such as the surface where the first base edge 301 of the cross-section is located) is greater than 20 degrees and less than 90 degrees. The orthographic projection of the first surface on the base substrate 01 falls into the orthographic projection of the second surface of the second portion 320 away from the base substrate 01 (such as the surface where the second base edge 302 of the cross-section is located) on the base substrate 01, and the distance between the orthographic projection of the edge of the first surface and the orthographic projection of the edge of the second surface is not greater than 5 microns. For example, the distance between the orthographic projection of the edge of the first surface and the orthographic projection of the edge of the second surface is not greater than 4 microns, or not greater than 3 microns, or not greater than 2 microns, or the like, and the distance between the orthotropic projection of the edge of the first surface and the orthographic projection of the edge of the second surface may be any numerical value between greater than 0 and less than 5 microns, which will not be enumerated again here.

For example, as shown in Fig. 2, the thickness of the defining structure 300 is greater than 1 micron. For example, the thickness of the defining structure 300 may be 1.5 microns to 2 microns. For example, the thickness of the defining structure 300 is not greater than 4.5 microns. For example, the thickness of the defining structure 300 is not greater than 4 microns. For example, the thickness of the defining structure 300 is not greater than 3.5 microns. For example, the thickness of the defining structure 300 is not greater than 3 microns. For example, the thickness of the defining structure 300 is not greater than 2.5 microns. The thickness of the defining structure 300 provided in an embodiment of the present disclosure may be any numerical value greater than 0 and less than 5 microns, which will not be enumerated again herein.

In some examples, as shown in Fig. 2, the thickness of the defining structure 300 is greater than that of the first electrode 110, and the thickness of at least part of the pixel-defining portion 230 that does not overlap with the defining structure 300 in the direction perpendicular to the base substrate 01 is greater than the thickness of the defining structure 300. By setting the thickness relationship between the defining structure 300, the first electrode 110 and the pixel-defining portion 230, at least one layer of the light-emitting function layer 130 of adjacent sub-pixels of different colors may be isolated to reduce crosstalk without affecting the normal luminous state of the sub-pixels.

For example, as shown in Fig. 2, the distance between a surface of the pixel-defining portion 230 away from the base substrate 01 and the base substrate 01 at an overlapping position between the pixel-defining portion 230 and the defining structure 230 is H1, and the distance between the surface of the pixel-defining portion 230 away from the base substrate 01 and the base substrate 01 at a position not overlapping between the pixel-defining portion 230 and the defining structure 300 is H2 or H3, and both H2 and H3 are less than H1. For example, the difference between H1 and H2 is no greater than 5 microns. For example, the difference between H1 and H3 is no greater than 5 microns.

For example, as shown in Fig. 2, the thickness of the pixel-defining portion 230 at the overlapping position between the pixel-defining portion 230 and the defining structure 230 may be 2 microns to 3 microns, such as 2.5 microns to 2.8 microns, and 2.735 microns. For example, the thickness of the pixel-defining portion 230 may be 1.1 microns to 1.5 microns, such as 1.217 microns, and the thickness of the defining structure 300 may be 1.3 microns to 1.7 microns, such as 1.518 microns.

In some examples, as shown in Fig. 1 and Fig. 2, the orthographic projection of the defining structure 300 on the base substrate 01 does not overlap with the orthographic projection of the first opening 210 on the base substrate 01, and the second opening 220 exposes the second portion 320 of the defining structure 300. For example, the defining structure 300 is only exposed by the second opening 220 of the pixel-defining pattern 200, and the second portion 320 of the defining structure 300 exposed by the second opening 220 isolates at least one layer of the light-emitting functional layer 130, such as a charge-generating layer, or the charge-generating layer and all the layers between the charge-generating layer and the base substrate 01, such as all the film layers in the light-emitting functional layers 130. For example, the second electrode 120 is isolated at the edge of the defining structure 300 exposed by the second opening 220.

For example, as shown in Fig. 2, the portion of the defining structure 300 that is not covered by the pixel-defining portion 230, such as the surface of the second portion 320 away from the base substrate 01, extends in the direction of line AA' by a distance of not greater than 10 microns.

In some examples, as shown in Fig. 1 and Fig. 2, an insulating layer 03 is further provided between the first electrode 110 and the base substrate 01, the first electrode 110 and the defining structure 300 are both in contact with the insulating layer 03, the defining structure 300 and the first electrode 110 are spaced apart, and the distance between the defining structure 300 and the first electrode 110 closest to it is not greater than 10 microns. The first electrode 110 closest to the defining structure 300 refers to the defining structure 300 and the first electrode 110 both covered by the pixel-defining portion 230 located between the first opening 210 and the second opening 220. The distance between the defining structure 300 and the first electrode 110 closest to it refers to the distance between the bottom edge of one side of the defining structure 300 close to the base substrate 01 and the first electrode 110. While spacing the defining structure 300 and the first electrode 110 apart, the distance between the first electrode 110 and the defining structure 300 needs to be considered to ensure that the defining structure 300 does not cause an impact on the light emitting effect of the sub-pixel 10.

For example, as shown in Fig. 2, the insulating layer 03 may be a planarization layer.

For example, as shown in Fig. 2, the distance between the defining structure 300 and the first electrode 110 is greater than 1 micron. For example, the distance between the defining structure 300 and the first electrode 110 is not greater than 9 microns. For example, the distance between the defining structure 300 and the first electrode 110 may be 2 microns to 8 microns. In the embodiments of the present disclosure, the distance between the defining structure 300 and the first electrode 110 may be any values greater than 0 microns and less than 10 microns, which will not be enumerated again herein.

For example, as shown in Fig. 2, when defining structure 300 and the first electrode 110 are spaced apart, the first electrode 110 can be patterned first, and then the defining structure 300 can be patterned to prevent affecting the flatness of the first electrode 110. It is also possible to first pattern to form the defining structure 300, and then pattern to form the first electrode 110 to ensure the outline of the first opening 210 of the pixel-defining pattern 200.

In some examples, as shown in Fig. 1 and Fig. 2, the part of the defining structure 300 between two adjacent sub-pixels 10 of different colors includes at least one sub-defining structure 330. For example, the defining structure 300 includes a plurality of sub-defining structures 330, and at least one sub-defining structure 330 is arranged between two adjacent sub-pixels 10 of different colors. The display substrate in Fig. 1 schematically shows that there is one sub-defining structure 330 provided between two adjacent sub-pixels 10 of different colors.

In some examples, as shown in FIG, 1, two adjacent sub-pixels 10 of different colors include a first color sub-pixel 101 and a second color sub-pixel 102.

In some examples, as shown in Fig. 1, the first color sub-pixel 101 includes a red sub-pixel or a green sub-pixel, and the second color sub-pixel 102 includes a blue sub-pixel. For example, Fig. 1 schematically shows that the first color sub-pixel 101 is the green sub-pixel and the second color sub-pixel 102 is the blue sub-pixel. For example, the plurality of sub-pixels 10 further includes a third color sub-pixel 103, and the third color sub-pixel 103 is the red sub-pixel. The embodiments of the present disclosure are not limited thereto, and the colors of the first color sub-pixel 101, the second color sub-pixel 102 and the third color sub-pixel 103 are interchangeable.

For example, as shown in Fig. 1, the area of a light-emitting region 010 of one blue sub-pixel is larger than that of a light-emitting region 010 of one red sub-pixel 010, and the area of a light-emitting region 010 of one red sub-pixel is larger than that of a light-emitting region 010 of one green sub-pixel 010.

For example, as shown in Fig. 1, the sub-pixel 10 includes a first pixel group and a second pixel group arranged alternately in the Y direction, the first pixel group and the second pixel group are offset with respect to each other in the X direction, the first pixel group includes red sub-pixels and blue sub-pixels alternately arranged along the X direction, and the second pixel group includes green sub-pixels arranged in the X direction. For example, one red sub-pixel is surrounded by four green sub-pixels, and one blue sub-pixel is surrounded by four green sub-pixels.

In some examples, as shown in Fig. 1, at least one sub-defining structure 330 includes an annular sub-defining structure 330 surrounding a light-emitting region 010 of at least one sub-pixel 10. For example, the light-emitting region 010 of the sub-pixel 10 of the same color is surrounded by a ring-shaped sub-defining structure 330 to improve the uniformity of the height of the pixel-defining portion 230 around the light-emitting region 010.

For example, as shown in Fig. 1, the light-emitting region 010 of the third color sub-pixel 103 is surrounded by the annular sub-defining structure 330, for example, the light-emitting region 010 of the red sub-pixel is surrounded by the annular sub-defining structure 330. Of course, the embodiments of the present disclosure are not limited thereto. For example, the light-emitting region 010 of the green sub-pixel is surrounded by the annular sub-defining structure 330.

For example, as shown in Fig. 1, the orthotropic projection of the annular sub-defining structure 330 on the base substrate 01 overlaps with the orthotropic projection of the first electrode 110 of the third color sub-pixel 103 on the base substrate 01. For example, the annular sub-defining structure 330 is located between the first color sub-pixel 101 and the third color sub-pixel 103, and the orthotropic projection of the annular sub-defining structure 330 on the base substrate 01 overlaps with the orthotropic projection of the first electrode 110 of the first color sub-pixel 101 on the base substrate 01.

For example, as shown in Fig. 1, a strip-shaped sub-defining structure 330 is arranged between the first color sub-pixel 101 and the third color sub-pixel 103. For example, the light-emitting region 010 of the first color sub-pixel 101 is quadrilateral, such as including two long edges parallel to each other and two short edges parallel to each other, and the two long edges and two short edges are connected end to end in turn. For example, the strip-shaped sub-defining structure 330 is located on a side close to a long edge of the light-emitting region 010 of the first color sub-pixel 101. For example, the strip-shaped sub-defining structure 330 is provided parallel to the long edge of the light-emitting region 010 of the first color sub-pixel 101.

For example, as shown in Fig. 1, in the extension direction of the long edge of the light-emitting region 010 of the first color sub-pixel 101, the length of the strip-shaped sub-defining structure 330 is greater than the length of the long side, so that it is possible to better isolate at least one layer of the light-emitting functional layer 130 between the first color sub-pixel 101 and the second color sub-pixel 102.

In some examples, as shown in Fig. 1, at least one second opening 220 is shaped as a strip, and at least one second opening 220 is located between two adjacent sub-pixels 10 of different colors, and the long sides of the strip are perpendicular to the direction of the two adjacent sub-pixels 10 of different colors. For example, each second opening 220 is strip-shaped.

For example, as shown in Fig. 1, the second opening 220 with a strip shape is parallel to the strip-shaped sub-defining structure 330, and the length of the second opening 220 is not greater than the length of the strip-shaped sub-defining structure 330, whereby the length of the second opening 220 determines the size used to block at least one layer of the light-emitting functional layer, thereby determining the degree of crosstalk between two adjacent sub-pixels 10 of different colors.

For example, as shown in Fig. 1, the lengths of the second openings 220 on both sides of the long edges of the light-emitting region 010 of the first color sub-pixel 101 are the same as the lengths of the strip-shaped sub-emitting structures 330 exposed by the second openings. At this time, it is necessary to control the uniformity of the second opening and the defining structure at different positions in the pixel-defining pattern to ensure the uniformity of the isolation effect of at least one layer of the light-emitting functional layer.

In some examples, as shown in Fig. 1, the long edge of the strip-shaped second opening 220 is parallel to the edge of the first opening 210 closest to it. For example, the first opening 210 closest to the long edge of the strip-shaped second opening 220 is the first opening 210 exposing the first electrode 110 of the first color sub-pixel 101 or the first electrode 110 of the second color sub-pixel 102, and the long edge of the strip-shaped second opening 220 is parallel to the edge of the first opening 210. For example, the edges of the light-emitting region 010 of the first color sub-pixel 101 and the adjacent second color sub-pixel 102 are set parallel to each other, and the long edge of the second opening 220 between the adjacent first color sub-pixel 101 and the second color sub-pixel 102 is parallel to the edge of the light-emitting region 010 of the sub-pixels of two colors.

For example, as shown in Fig. 1, the orthographic projection of the strip-shaped sub-defining structure 330 located between the first color sub-pixel 101 and the second color sub-pixel 102 on the base substrate 01 overlaps with the orthographic projection of the first electrode 110 of at least one of the first color sub-pixel 101 and the second color sub-pixel 102 on the base substrate 01.

For example, as shown in Fig. 1, the number of second openings 220 for exposing the annular sub-defining structure 330 surrounding the same third color sub-pixel 103 is four, each second opening 220 is in a strip shape, and the long edges of the four second openings 220 are parallel to the four edges of the quadrilateral light-emitting region 010 of the third color sub-pixel 103, respectively.

For example, as shown in Fig. 1, the long edges of the four second openings 220 surrounding the third color sub-pixel 103 all have a length larger than that of the edges of the light-emitting region 010 of the third color sub-pixel 103. For example, the four second openings 220 surrounding the third color sub-pixel 103 are located between the third color sub-pixel 103 and the first color sub-pixel 101.

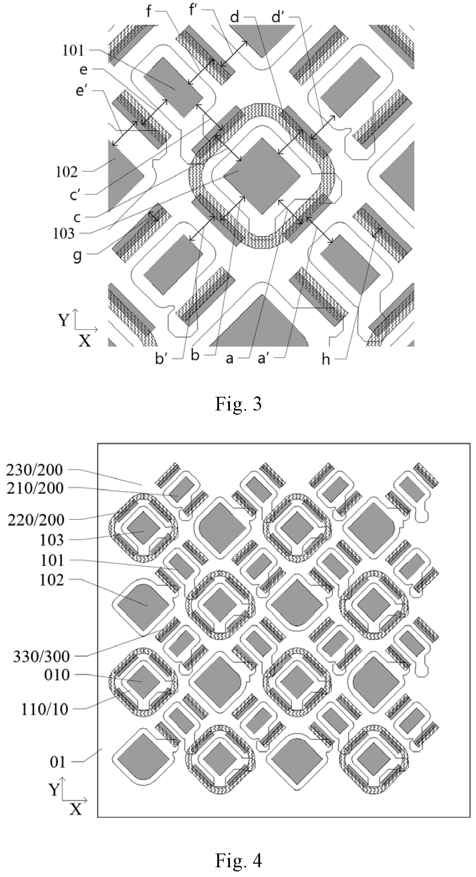

Fig. 3 is a partial enlarged view of the display substrate shown in Fig. 1.

For example, as shown in Fig. 1 and Fig. 3, the distance between the four edges of the light-emitting region 010 of the third color sub-pixel 103 and the edges exposed by the annular sub-defining structure 330 by the second opening 220 are *a, b, c,* and *d,* respectively. For example, the values of *a, b, c,* and *d* are in the following ranges: s0≤ a≤20 µm, 0≤*b*≤20 µm, 0≤c≤20 µm, 0≤d≤20 µm. For example, all of *a, b, c,* and *d* can be equal to each other, or at least one of them can be unequal to the other three. For example, the distance between the annular sub-defining structure 330 and the light-emitting regions 010 of the four first-color sub-pixels 101 surrounding it are a', b', c', d', respectively. For example, the values of a', b', c', d' are in the following ranges: 0≤a'≤20 µm, 0≤b'≤20 µm, 0≤c'≤20 µm, 0≤d≤20 µm. For example, all of a', b', c', d' can be equal, or at least one can be unequal to the other three, such as a'=c'≠b'=d', or a' ≠b' ≠c' ≠d'. For example, the first color sub-pixel 101 is only provided with a long strip-shaped sub-defining structure 330 close to the long edge of its light-emitting region 010, and the distance between the long edges of the light-emitting region 010 of the first-color sub-pixel 101 and two strip-shaped sub-defining structures 330 adjacent to the long edges are *e* and *f*, respectively. For example, the values of *e* and *f* are in the following ranges: 0≤*e*≤20 µm, 0≤*f*≤20 µm. For example, *e* and *f* can be equal or unequal. For example, the second opening 220 can be a slot between the sub-pixels 10 in the pixel-defining pattern 200, the width of the second opening 220 needs to be considered for the width of the defining structure 300, and the width of the second opening 220 needs to consider the distance between the light-emitting regions 010 of the adjacent sub-pixels 10, the width of the second opening 220 is g, and the value range of g includes: 0≤*g*≤20 µm. For example, the width of the second opening 220 at different locations can be equal. For example, the width of the sub-defining structure 330 can be *h,* and the value range of *h* includes 0≤*h*≤5 µm. For example, the overlapping width of the second opening 220 and the sub-defining structure 330 needs to consider the isolating effect of the material of the light-emitting functional layer 130, such as the overlapping width is between 0 to *h.*

In some examples, as shown in Fig. 1, at least one sub-defining structure 330 includes one sub-defining structure 330, and the edge of the first portion 310 of the sub-defining structure 330 is closer to the edge of the light-emitting region 010 of the first color sub-pixel 101. For example, one sub-defining structure 330 is provided between the first color sub-pixel 101 and the second color sub-pixel 102, and the distance between the sub-defining structure 330 and the light-emitting region 010 of the first color sub-pixel 101 is smaller than the distance between the sub-defining structure 330 and the light-emitting region 010 of the second color sub-pixel 102.

For example, as shown in Fig. 1, one sub-defining structure 330 is provided between the first-color sub-pixel 101 and the third-color sub-pixel 103, and the sub-defining structure 330 is closer to the third-color sub-pixel 103.

For example, as shown in Fig. 1, only the edge of the second portion 320 of the defining structure 300 plays the role of isolating the light-emitting functional layer 130. Setting the edge closer to the red sub-pixel may maximize the isolating effect of the red sub-pixel, but not limited thereto, the edge can also be set closer to the green sub-pixel. For example, Fig. 1 schematically shows that part of the edge of the defining structure 300 that functions to isolate the light-emitting functional layer 130 located between the blue sub-pixel and the green sub-pixel is closer to the green sub-pixel, but is not limited to, and the edge can also be closer to the blue sub-pixel. For example, the annular sub-defining structure 330 surrounding the red sub-pixel can also be sub-defining structures 330 having a strip shape located on both sides of the green sub-pixel. For example, the strip-shaped sub-defining structures 330 located on both sides of the green sub-pixel can also be sub-defining structure 330 having an annular shape. For example, the second opening 220 cannot be set up as a closed ring structure around any light-emitting region 010. For example, the number of the second openings 220 surrounding any light-emitting area 010 can be multiple and are arranged at intervals, and the size of the second opening 220 is related to the process.

In some examples, as shown in Fig. 1, there are two closest sub-defining structures 330 are arranged on both sides of the same sub-pixel 10, and one of the two sub-defining structures 330 is a structure that is rotationally symmetric with respect to the center of the light-emitting region 010 of the same sub-pixel 10 of the other one of the two sub-defining structures. For example, the two sub-defining structures 330 on both sides of the long edges of the light-emitting region 010 of the first color sub-pixel 101 can be symmetrically distributed relative to the center line of the light-emitting region 010 extending along the direction of its long edges, so as to improve the symmetry of the pixel-defining portion 230. For example, one of the above two sub-defining structures 330 is rotated by 180 degrees around the center of the light-emitting region 010 and then coincides with the other sub-defining structure 330. On the one hand, the symmetrical design can provide symmetrical isolation effect in a specific direction, and on the other hand, when the symmetrical arranged sub-defining structures play the role of supporting the mask, it is conducive to improving the uniformity of the support force of the evaporation mask.

For example, Fig. 2 only shows a defining structure 300 located on one side of the first color sub-pixel 101, for example, both sides of the first color sub-pixel 101 are provided with the defining structure 300. For example, the sub-defining structures 330 located on both sides of the same sub-pixel 10 both have one side edge covered by the pixel-defining portion 230 and the other side edge exposed by the second opening 220. For example, the defining structure 300 located on two sides of the same sub-pixel 10 can be symmetrically distributed relative to the centerline of the light-emitting region 010 of the sub-pixel 10. For example, second openings 220 located on two sides of the same sub-pixel 10 can be symmetrically distributed relative to the center of the light-emitting region 010 of the sub-pixel 10.

For example, as shown in Fig. 1, the edge of the defining structure 300 is closer to the light-emitting region 010 of the first color sub-pixel 101, such as the green sub-pixel, than the edge of the second opening 220. For example, the first portion 310 of the defining structure 300 is closer to the light-emitting region 010 of the first color sub-pixel 101 than the second portion 320 of the defining structure 300. For example, the edge of the defining structure 300 is closer to the light-emitting region 010 of the third color sub-pixel 103, such as the red sub-pixel, than the edge of the second opening 220. For example, the first portion 310 of the defining structure 300 is closer to the light-emitting region 010 of the third color sub-pixel 103 than the second portion 320 of the defining structure 300.

For example, as shown in Fig. 1, the edge of the defining structure 300 is farther away from the light-emitting region 010 of the second color sub-pixel 102, such as the blue sub-pixel, than the edge of the second opening 220. For example, the second portion 320 of the defining structure 300 is closer to the light-emitting region 010 of the second color sub-pixel 102 than the first portion 310 of the defining structure 300.

The data writing voltage of different color sub-pixels is different, resulting in the blue sub-pixel and green sub-pixel being susceptible to low gray scale caused by the current leakage of the red sub-pixel when the low gray scale display screen is displayed, such as the red sub-pixel crosstalk to the blue sub-pixel or the green sub-pixel. Therefore, the display substrate provided in this example can increase the proportion of channels of the second electrode around the light-emitting region of the blue sub-pixel by setting the defining structure farther away from the blue sub-pixels, thereby improving the continuity of the second electrode, preventing the increase of cross-voltage, and improving the display uniformity.

Fig. 4 is a schematic diagram of a partial planar structure of the display substrate provided according to another example of an embodiment of the present disclosure. The display substrate shown in Fig. 4 differs from the display substrate shown in Fig. 1 in that the relative positional relationships among the defining structure 300, the second opening 220, and the light-emitting region 010 of the sub-pixel 10 of different colors are different.

For example, as shown in Fig. 4, the edge of the second opening 220 is closer to the light-emitting region 010 of the first color sub-pixel 101 than the edge of the defining structure 300. For example, the second portion 320 of the defining structure 300 is closer to the light-emitting region 010 of the first color sub-pixel 101 than the first portion 310. For example, the edge of the second opening 220 is closer to the light-emitting region 010 of the third color sub-pixel 103 than the edge of the defining structure 300. For example, the second portion 320 of the defining structure 300 is closer to the light-emitting region 010 of the third color sub-pixel 103 than the first portion 310 of the defining structure 300.

For example, as shown in Fig. 4, the defining structure 300 located between the first color sub-pixel 101 and the third color sub-pixel 103 is closer to the light-emitting region 010 of the third-color sub-pixel 103, so as to maximize the isolating effect of at least one layer of the light-emitting functional layer 130 of the third-color sub-pixel 103, thereby preventing crosstalk.

In addition to the position relationship among the defining structure, the second opening and the light-emitting region shown in Fig. 4, which is different from the position relationship among the defining structure, the second opening and the light-emitting region shown in Fig. 1, other structures in the display substrate shown in Fig. 4 can have the same characteristics as the other structures in the display substrate shown in Fig. 1, which will not be described again here. The shape of the defining structure in the display substrate shown in Fig. 4 can be the same as the shape of the defining structure in the display substrate shown in Fig. 1, the shape of the second opening shown in Fig. 4 can be the same as the shape of the second opening shown in Fig. 1, and the shape and distribution of each light-emitting region shown in Fig. 4 can be the same as the shape and distribution of each light-emitting region in the substrate shown in Fig. 1.

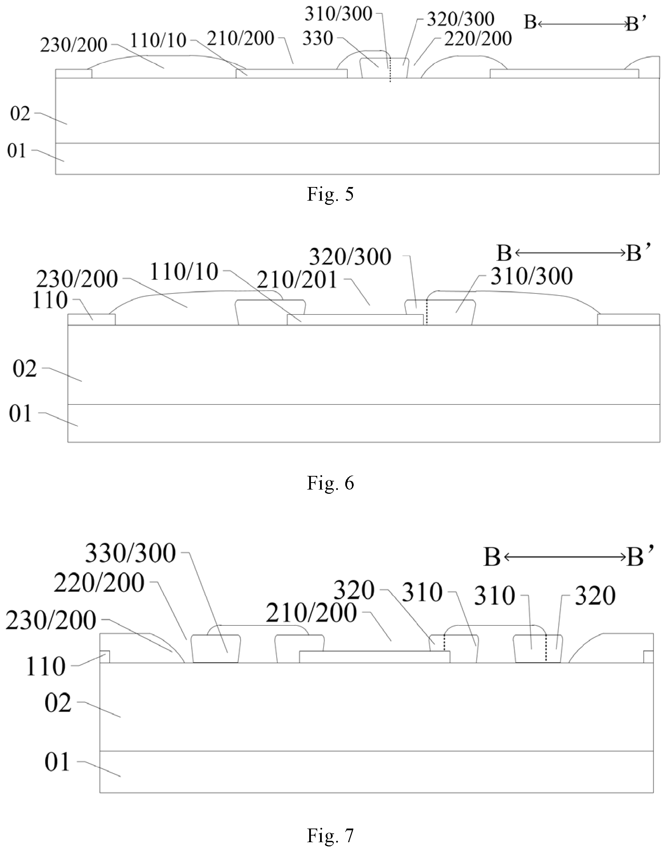

Fig. 5 is a schematic diagram of a partial cross-sectional structure of a display substrate provided according to another example of an embodiment of the present disclosure. Fig. 5 may be a schematic diagram of a partial cross-sectional structure taken along the line BB' in the display substrate.

The display substrate shown in Fig. 5 differs from the display substrate shown in Fig. 1 to Fig. 3 in that the defining structure 300 is provided on only one side of the sub-pixel 10 of the same color.

For example, as shown in Fig. 5, the defining structure 300 is located only on one side of the first opening 210 of the pixel-defining pattern 200, and only the position of the defining structure 300 is provided with the second opening 220. For example, the defining structure 300 can be located on one side of a particular color sub-pixel 10, such as a red sub-pixel, a green sub-pixel, or a blue sub-pixel. For example, the defining structure 300 can be located between two specific color sub-pixels 10, such as between a green sub-pixel and a blue sub-pixel, or between a green sub-pixel and a red sub-pixel. For example, the defining structure 300 can correspond to three color sub-pixel 10. For example, the defining structure 300 may include a plurality of sub-defining structures 330, and the plurality of sub-defining structures 330 may be provided uniformly or at a specific location in the display region. The embodiments of the present disclosure do not limit the position of the defining structure, which can be set according to the needs of the product.

In the example shown in Fig. 5, except that the position of the defining structure 300 in the display substrate is different from the position of the defining structure 300 in the display substrate shown in Fig. 1 to Fig. 3, the other structures in the display substrate shown in Fig. 5 can have the same characteristics as the corresponding structures in the display substrate shown in Fig. 1 to Fig. 3, which will not be described again here. For example, the cross-section of the defining structure 300 shown in the display substrate shown in Fig. 5 can have the same characteristics as the cross-section of the defining structure 300 shown in the display substrate shown in Fig. 1 to Fig. 3, and will not be described again here.

Fig. 6 and Fig. 7 are schematic diagrams of partial cross-sectional structures of a display substrate provided according to different examples of an embodiment of the present disclosure. Fig. 6 and Fig. 7 may be a schematic diagram of a partial cross-sectional structure taken along the line BB' in the display substrate.

The display substrate shown in Fig. 6 differs from the display substrate shown in Fig. 1 to Fig. 3 in that the relative positional relationship between the defining structure 300 and the pixel-defining pattern 200 is different, and the relative positional relationship between the defining structure 300 and the first electrode 110 is different.

In some examples, as shown in Fig. 6, the defining structure 300 covers the edge of the first electrode 110. By covering the edge of the first electrode 110 with the defining structure 300, it is beneficial to prevent the edge of the pixel-defining portion 230 from being too thin to cover the first electrode 110, resulting in the exposure of the edge of the first electrode 110 and causing poor display performance.

In some examples, as shown in Fig. 6, the size of a part, of the defining structure 300, covering the first electrode 110 is not greater than 5 microns in the direction of arrangement of two adjacent sub-pixels 10 of different colors. For example, the size of the part, of the defining structure 300, covering the first electrode 110 is not greater than 5 microns in the direction of the line BB' shown in the figure. For example, in the extension direction of the line BB', the size of the part, of the defining structure 300, covering the first electrode 110 is greater than 0. For example, in the direction of the line BB' shown in the figure, the size of the part, of the defining structure 300, covering the first electrode 110 may be 1 micron, or 2 microns, or 3 microns. The size of the part, of the defining structure 300, covering the first electrode 110 may be any value greater than 0 microns and less than 5 microns, which will not be enumerated again herein.

For example, as shown in Fig. 6, the size of the part, of the defining structure 300, covering the first electrode 110 may be a size perpendicular to the extension direction of the defining structure 300.

In some examples, as shown in Fig. 6, the second portion 320 of the defining structure 300 is at least exposed by the first opening 210. For example, the area of the orthographic projection of the second portion 320 of the defining structure 300 on the base substrate 01 is smaller than the area of the orthographic projection of the first portion 310 of the defining structure 300 on the base substrate 01. For example, the defining structure 300 covers only part of the edges of the same first electrode 110 so that at least part, in the first opening 210, of the film layer is a continuous structure. The part of the defining structure 300 exposed by the first opening 210 and the first opening 210 together define the light-emitting region 010 of the sub-pixel 10.

For example, as shown in Fig. 6, all the openings 201 included in the pixel-defining pattern 200 in the display substrate are the first openings 210, the light-emitting functional layer 130 is continuously arranged at part of the first opening 210, and at least one layer of the light-emitting functional layer 130 at part of the first opening 210 is disconnected. For example, as shown in Fig. 6, the display substrate may not include the second opening 220 in the example shown in Fig. 1.

Fig. 6 schematically shows that edges of both sides of the first electrode 110 on the extension direction of the line BB' are covered by the defining structure 300. However, it is not limited thereto, and the first electrode 110 can also be configured so that one side edge of the first electrode 110 is covered by the defining structure 300, and the other edge of the first electrode 110 is covered by the pixel-defining portion 230.

For example, as shown in Fig. 6, in the direction perpendicular to the base substrate 01, the first portion 310 of the defining structure 300 does not overlap with the first electrode 110, and the second portion 320 of the defining structure 300 overlaps with the first electrode 110.

For example, as shown in Fig. 6, the edge of the first electrode 110 of one color sub-pixel 10 can be covered by the defining structure 300, and the edge of the first electrode 110 of another color sub-pixel 10 can be covered by the pixel-defining portion 230. For example, in two adjacent sub-pixels 10 of different colors, only the first electrode 110 of one sub-pixel 10 is covered by the defining structure 300, and the first electrode 110 of the other sub-pixel 10 is covered by the pixel-defining portion 230.

Of course, the embodiments of the present disclosure are not limited thereto. The defining structure 300 shown in Fig. 1 to Fig. 4 can also be combined into the defining structure 300 shown in Fig. 6. For example, the edge of the first electrode 110 at part of the positions is covered by the defining structure 300, and the first electrode 110 at the part of the positions is spaced apart from the defining structure 300.

In the example shown in Fig. 6, except that the position of the defining structure 300 and the pixel-defining pattern in the display substrate are different from the position of the defining structure 300 and the pixel-defining pattern 200 in the display substrate shown in Fig. 1 to Fig. 3, the other structures in the display substrate shown in Fig. 6 can have the same characteristics as the corresponding structures in the display substrate shown in Fig. 1 to Fig. 3, which will not be described again here. For example, the cross-section of the defining structure 300 shown in the display substrate shown in Fig. 6 can have the same characteristics as the cross-section of the defining structure 300 shown in the display substrate shown in Fig. 1 to Fig. 3, and will not be described again here.

Fig. 7 shows that two sub-defining structures 330 may be provided between two adjacent sub-pixels in the display substrate, one of the two sub-defining structures 330 covers the edge of the first electrode 110 and is exposed by the first opening 210, similar to the sub-defining structure 330 covering the edge of the first electrode 110 and being exposed by the first opening 210 as shown in Fig. 6.

In some examples, as shown in Fig. 7, at least one sub-defining structure 330 located between two adjacent sub-pixels includes two sub-defining structures 330 that are spaced apart from each other, the second portion 320 of one of the two sub-defining structures 330 is exposed by the first opening 210, and the second portion 320 of the other of the two sub-defining structures 330 is exposed by the second opening 220. By providing two sub-defining structures 330 between two adjacent sub-pixels, one of the two sub-defining structures 330 is exposed by the first opening 210 while covering the edge of the first electrode 110, and the other of the two sub-defining structures 330 is exposed by the second opening 220. This not only may further improve the disconnecting effect of the light-emitting functional layer 130, further reducing crosstalk, it is also possible to reduce the risk that the edge of the first electrode 110 is exposed to cause corrosion. Of course, the embodiment of the present disclosure is not limited thereto. For example, one of the two sub-defining structures 330 may only cover the edge of the first electrode 110 without being exposed by the first opening 210, and the other of the two sub-defining structures 330 is exposed by the second opening 220.

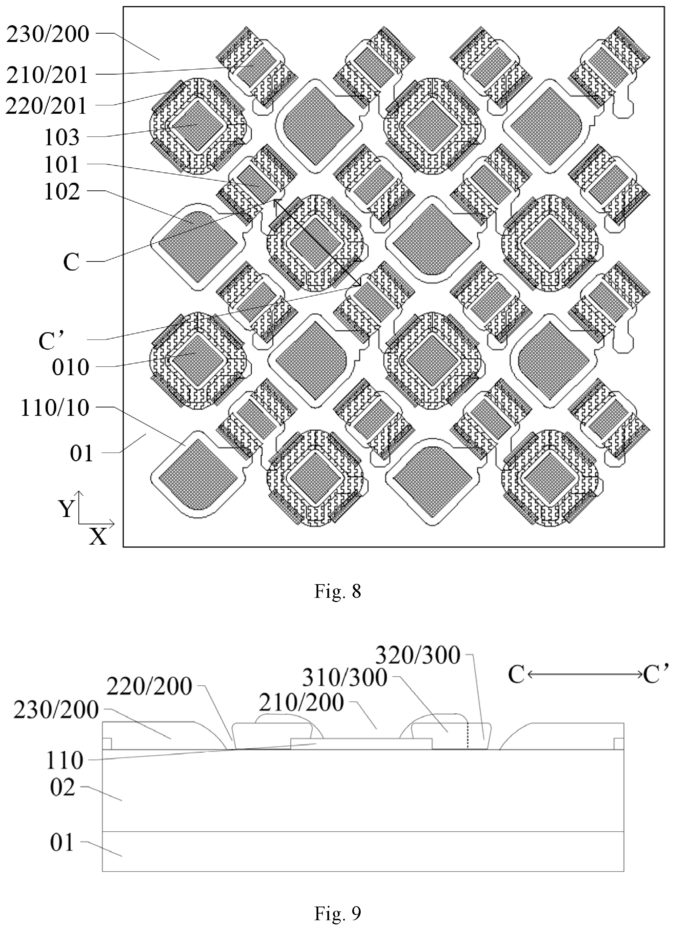

Fig. 8 is a schematic diagram of a partial planar structure of the display substrate provided according to another example of an embodiment of the present disclosure. Fig. 9 is a schematic diagram of a partial cross-sectional structure taken along the CC' line shown in Fig. 8. The display substrate shown in Fig. 8 differs from the display substrate shown in Fig. 1 in that the width of the defining structure 300 and the position relationship between the defining structure 300 and the first electrode 110. The display substrate shown in Fig. 9 differs from the display substrate shown in Fig. 6 in that the openings 201 exposing the defining structure 300 are different.

For example, as shown in Fig. 8 and Fig. 9, the defining structure 300 covers the edge of the first electrode 110, and the part of the defining structure 300 covering the edge of the first electrode 110 is the first portion 310 of the defining structure 300. For example, the first electrode 110 includes a portion exposed by the first opening 210, a portion covered by the pixel-defining portion 230, and a portion covered by the defining structure 300. By covering the edge of the first electrode 110 with the defining structure 300, it is beneficial to prevent the edge of the pixel-defining portion 230 from being too thin to cover the first electrode 110, resulting in the exposure of the edge of the first electrode 110 and causing poor display performance.

For example, as shown in Fig. 8 and Fig. 9, the second portion 320 of the defining structure 300 is only exposed by the second opening 220 and not exposed by the first opening 210.

In the example shown in Fig. 8 and Fig. 9, except that the position of the defining structure 300 in the display substrate is different from the position relationship between the defining structure 300 and the first electrode 110 in the display substrate shown in Fig. 1 to Fig. 3, the other structures in the display substrate shown in Fig. 8 and Fig. 9 can have the same characteristics as the corresponding structures in the display substrate shown in Fig. 1 to Fig. 3, which will not be described again here. For example, the cross-section of the defining structure 300 shown in the display substrate shown in Fig. 8 and Fig. 9 can have the same characteristics as the cross-section of the defining structure 300 shown in the display substrate shown in Fig. 1 to Fig. 3, and will not be described again here.

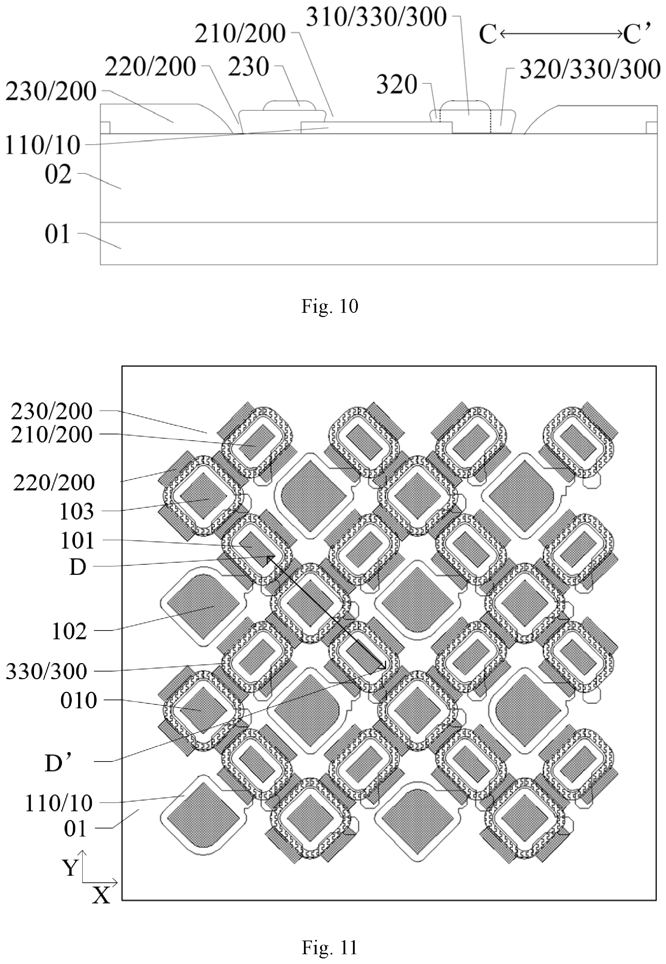

Fig. 10 is a schematic diagram of a partial cross-sectional structure of a display substrate provided according to another example of an embodiment of the present disclosure. The display substrate shown in Fig. 10 differs from the display substrate shown in Fig. 9 in the position relationship between the defining structure 300 and the first opening 210.

In some examples, as shown in Fig. 10, at least one sub-defining structure 330 located between two adjacent sub-pixels 10 includes one sub-defining structure 330, the side edge of the sub-defining structure 330 is exposed by the first opening 210, and the other side edge of the sub-defining structure 330 is exposed by the second opening 220. Exposing the edges of the two sides of the sub-defining structure 330 by the first opening 210 and the second opening 220 respectively and covering the edge of the first electrode 110 by the sub-defining structure 330 not only further improve the isolation effect of the light-emitting functional layer 130, further reducing crosstalk, but also reduce the risk of corrosion occurred at the exposed edge of the first electrode 110.

For example, as shown in Fig. 10, the sub-defining structure 330 includes two second portion 320 and the first portion 310 located between the two second portion 320, and the two second portion 320 are exposed by the first opening 210 and the second opening 220, respectively. For example, the area of the orthographic projection of the second portion 320 exposed by the first opening 210 on the base substrate 01 is not greater than the area of the orthotropic projection of the second portion 320 exposed by the second opening 220 on the base substrate 01.

In the example shown in Fig. 10, except that the position relationship of the defining structure 300, the pixel-defining pattern 200, and the first electrode 110 in the display substrate is different from the position relationship between the defining structure 300, the pixel-defining pattern 200, and the first electrode 110 in the display substrate shown in Fig. 1 to Fig. 3, the other structures in the display substrate shown in Fig. 10 can have the same characteristics as the corresponding structures in the display substrate shown in Fig. 1 to Fig. 3, which will not be described again here. For example, the cross-section of the defining structure 300 shown in the display substrate shown in Fig. 10 can have the same characteristics as the cross-section of the defining structure 300 shown in the display substrate shown in Fig. 1 to Fig. 3, and will not be described again here.

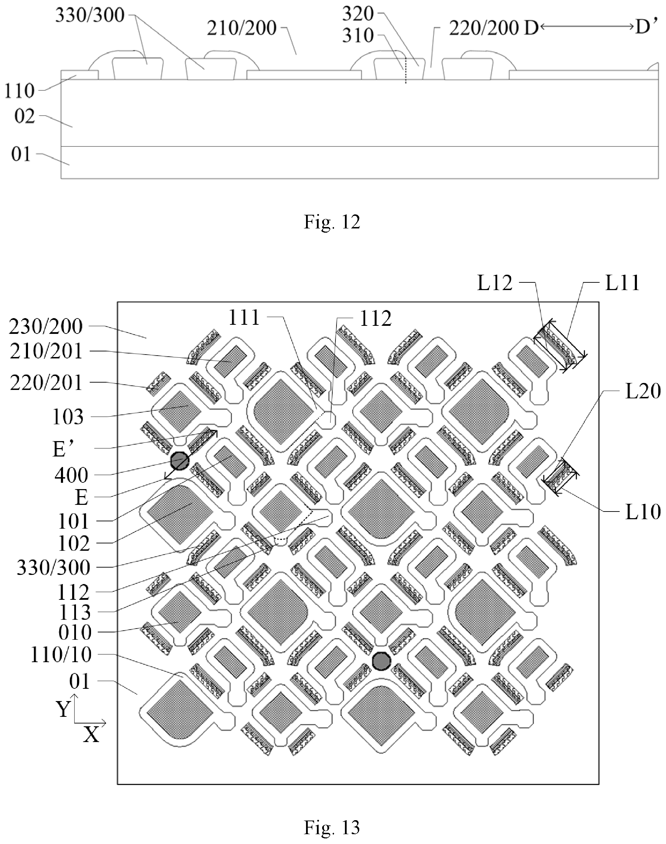

Fig. 11 is a schematic diagram of a partial planar structure of the display substrate provided according to another example of an embodiment of the present disclosure. Fig. 12 is a schematic diagram of a partial cross-sectional structure taken along the DD' line shown in Fig. 11. The display substrate shown in Fig. 11 differs from the display substrate shown in Fig. 1 in that the shape of the defining structure 300 surrounding the first color sub-pixel 101 is different, and the position relationship between the defining structure 300 surrounding the first color sub-pixel 101 and the second opening 220 is different.

For example, as shown in Fig. 11 and Fig. 12, one sub-defining 330 is arranged between the first color sub-pixel 101 and the second color sub-pixel 102 that are provided adjacent to each other, and two sub-defining structures 330 are arranged between the first color sub-pixel 101 and the third color sub-pixel 103 that are provided adjacent to each other. Varying the number of sub-defining structures 330 provided between different color sub-pixels may reduce the crosstalk between the first color sub-pixel 101 and the third color sub-pixel 103 that are prone to crosstalk, while increasing the size of the channel of the second electrode 120 around the second color sub-pixel 102, thereby increasing the continuity of the second electrode 120. Of course, the embodiment of the present disclosure is not limited thereto. The two sub-defining structures 330 may also be arranged between the first color sub-pixel 101 and the second color sub-pixel 102.

In some examples, as shown in Fig. 11 and Fig. 12, at least one sub-defining structure 330 located between two adjacent sub-pixels includes two sub-defining structures 330 that are spaced apart, and the edges of the two sub-defining structures 330 opposite each other are exposed by the same second opening 220, further improving the isolating effect of the light-emitting functional layer 130 of the adjacent two sub-pixels 10. For example, two second portions 320 in the two sub-defining structures 330 are in close proximity to each other.

In some examples, as shown in Fig. 11 and Fig. 12, the two sub-defining structures 330 are two annular sub-defining structures 330 surrounding light-emitting regions 010 of two different color sub-pixels 10. For example, the light-emitting region 010 of the first color sub-pixel 101 and the light-emitting region 010 of the third color sub-pixel 103 are respectively surrounded by the two annular sub-defining structures 330, and the edges of the two annular sub-defining structures 330 close to each other are exposed by the same second opening 220. For example, a plurality of second openings 220 expose each annular sub-defining structure 330, and the plurality of second openings 220 are spaced apart from each other.

By setting the light-emitting regions of the two adjacent sub-pixels to be surrounded by the annular sub-defining structure, the height uniformity of the pixel-defining portion around the light-emitting regions of the two adjacent sub-pixels is improved.

Fig. 11 schematically shows that the light-emitting region 010 of the first color sub-pixel 101 and the light-emitting region 010 of the third-color sub-pixel 103 are both surrounded by annular sub-defining structures 330. However, it is not limited thereto. For example, the light-emitting region 010 of the first color sub-pixel 101 and the light-emitting region 010 of the second color sub-pixel 102 are both surrounded by the annular sub-defining structures 330. For example, the light-emitting region 010 of the second color sub-pixel 102 and the light-emitting region 010 of the third color sub-pixel 103 are both surrounded by the annular sub-defining structures 330. For example, the light-emitting region 010 of the first color sub-pixel 101, the light-emitting region 010 of the second color sub-pixel 102, and the light-emitting region 010 of the third color sub-pixel 103 are all surrounded by the annular sub-defining structures 330.

The display substrate in the example shown in Fig. 11 and Fig. 12 is different from the display substrate shown in Fig. 1 to Fig. 3 except that the shape of the defining structure 300 surrounding the first color sub-pixel 101, the position relationship between the defining structure 300 and the second opening 220 around the first color sub-pixel 101, the other structures in the display substrate shown in Fig. 11 and Fig. 12 can have the same characteristics as the corresponding structures in the display substrate shown in Fig. 1 to Fig. 3, and will not be described again here. For example, the cross-section of the defining structure 300 in the display substrate shown in Fig. 10 can have the same characteristics as the cross-section of the defining structure 300 in the display substrate shown in Fig. 1 to Fig. 3, and will not be described again here.

It should be noted that the display substrate in the examples shown in Fig. 1 to Fig. 11 schematically shows that the defining structure and the second opening overlap with the first electrode of the sub-pixel, but the schematic diagram does not limit the overlapping relationship of the defining structure and the second opening and the first electrode. For example, as shown in the examples shown in Fig. 1 to Fig. 11, at least one of the defining structure and the second opening in the display substrate may not overlap with any first electrode.

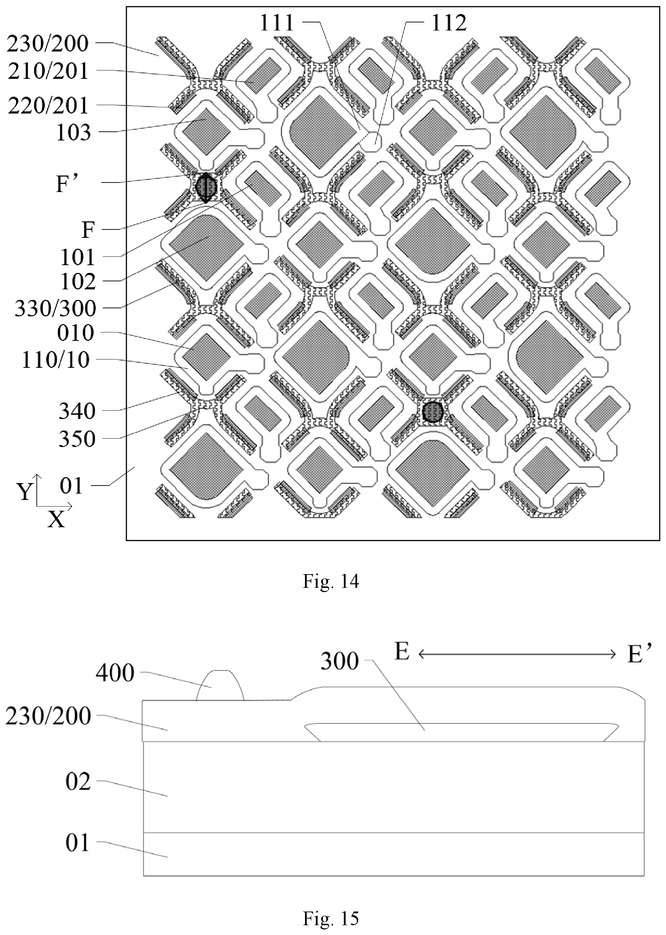

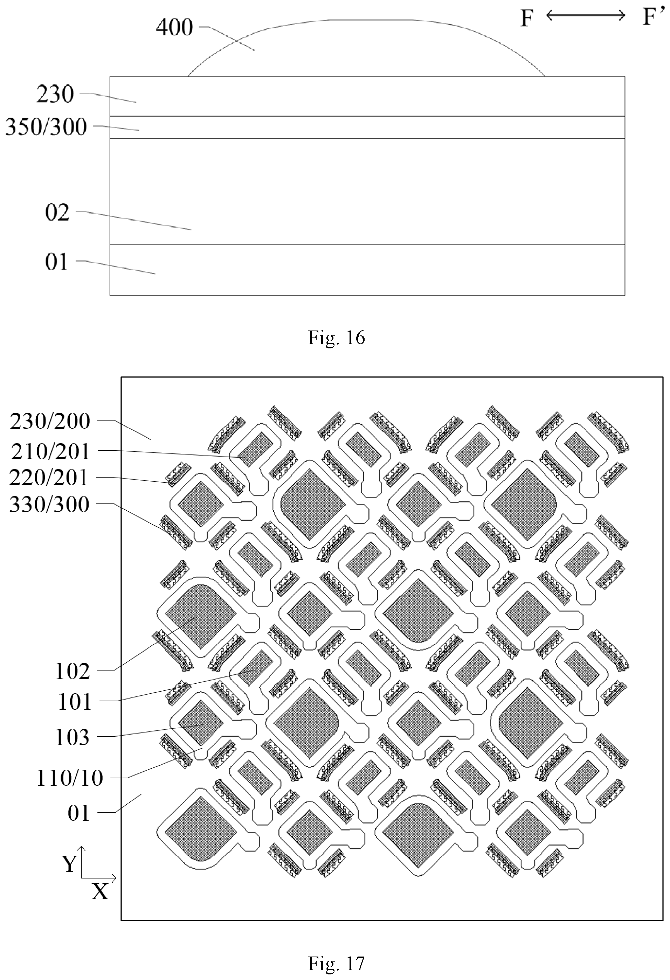

Fig. 13 and Fig. 14 are schematic diagrams of partial planar structures of a display substrate provided according to different examples of an embodiment of the present disclosure; Fig. 15 is a schematic diagram of a partial cross-sectional structure taken along the EE' line shown in Fig. 13. Fig. 16 is a schematic diagram of a partial cross-sectional structure taken along the FF' line shown in Fig. 14.

The display substrates shown in Fig. 13 and Fig. 14 differ from those shown in Fig. 1 to Fig. 3 in that the shape and position of the defining structure 300 and the second opening 220 are different. Fig. 13 and Fig. 14 also show a photo spacer 400.

In some examples, as shown in Fig. 13 to Fig. 16, the display substrate further includes the photo spacer 400 located on a side of the pixel-defining portion 230 away from the base substrate 01, and the material of the defining structure 300 is different from that of the photo spacer 400. For example, the photo spacer 400 (PS) is configured to support a fine metal mask (FMM mask) upon manufacturing the light-emitting layer.

For example, as shown in Fig. 13 to Fig. 16, the material of the defining structure 300 may include a negative photoresist, and the material of the photo spacer 400 may include a positive photoresist. For example, the positive photoresist is a photoresist that degrades the illuminated part and dissolves in the developer, leaving behind a pattern of the non-exposed part that matches the pattern of the mask. The negative photoresist refers to a photoresist that has a cross-chain reaction in the illuminated part and becomes an insoluble substance, and the non-exposed part is dissolved by the developer, and the pattern formed is complementary to the pattern of the mask.

In some examples, as shown in Fig. 13 to Fig. 16, the thickness of the photo spacer 400 is not greater than 5 microns, and the thickness of the pixel-defining portion 230 is not greater than 5 microns. For example, the thickness of the photo spacer 400 is not greater than 4 microns, and the thickness of the pixel-defining portion 230 is not greater than 4 microns. For example, the thickness of the pixel-defining portion 230 is greater than 1 micron. For example, the thickness of the photo spacer 400 is greater than 1 micron. For example, in the direction perpendicular to the base substrate 01, the thickness of the overlap between the pixel-defining portion 230 and the defining structure 300 can be smaller than the thickness of the defining structure 300. For example, in the direction perpendicular to the base substrate 01, the thickness of the overlapping part of the pixel-defining portion 230 and the defining structure 300 can be 1.1 microns to 1.3 microns, and the thickness of the defining structure 300 can be 1.4 microns to 1.6 microns.

For example, as shown in Fig. 13 and Fig. 15, the photo spacer 400 does not overlap with the defining structure 300 in the direction perpendicular to the base substrate 01. For example, the thickness of the photo spacer 400 can be greater than the thickness of the defining structure 300 to support the mask plate by the photo spacer 400.

In some examples, as shown in Fig. 14 and Fig. 16, the orthographic projection of the photo spacer 400 on the base substrate 01 overlaps with the orthographic projection of the defining structure 300 on the base substrate 01. For example, the orthographic projection of the photo spacer 400 on the base substrate 01 completely falls within the orthographic projection of the defining structure 300 on the base substrate 01. Therefore, the structure including the photo spacer 400 and defining structure 300 is used to support the mask plate, which is conducive to improving the support effect.

In some examples, as shown in Fig. 14 and Fig. 16, the defining structure 300 includes a plurality of defining portions 340 and a connecting portion 350 connecting at least a part of the plurality of defining portions 340, the defining portion 340 overlaps with the second opening 220 in the direction perpendicular to the base substrate 01, and the orthographic projection of the connecting portion 350 on the base substrate 01 completely falls into the orthographic projection of the pixel-defining portion 230 on the base substrate 01. The orthographic projection of the photo spacer 400 on the base substrate 01 completely falls into the orthographic projection of the connecting portion 350 on the base substrate 01.

For example, as shown in Fig. 14, the defining portion 340 is located between the adjacent first color sub-pixel 101 and the second color sub-pixel 102, or between the adjacent first color sub-pixel 101 and the third color sub-pixel 103, and the second portion 320 of the defining portion 340 is exposed by the second opening 220. For example, the connecting portion 350 may be located between the four defining portions 340 and connect the four defining portions 340. For example, the defining portion 340 and the connecting portion 350 can be integrated structures. By setting the defining structure to include the defining portions and connecting portions that are connected with each other, the density of the defining structure can be increased to increase the uniformity of the line width, and the symmetry of the defining structure can further be improved.

For example, as shown in Fig. 14 and Fig. 16, the sum of the heights of the defining structure 300, the pixel-defining portion 230, and the photo spacer 400 that are stacked is not greater than 10 microns. For example, the sum of the heights of the defining structure 300, the pixel-defining portion 230, and the photo spacer 400 that are stacked is not greater than 9 microns, or not greater than 7 microns, or not greater than 5 microns.

For example, as shown in Fig. 14, in the direction perpendicular to the base substrate 01, the size of the connecting portion 350 overlapping the photo spacer 400 in the Y direction is larger than that of the connecting portion 350 that does not overlap with the photo spacer 400 in the Y direction.

For example, as shown in Fig. 14, the defining structure 300 including four defining portions 340 and one connecting portion 350 can be a special-shaped defining structure 300, the defining structure 300 surrounding the first color sub-pixel 101 may include two special-shaped defining structures 300 spaced apart with each other, and the defining structure 300 surrounding the third color sub-pixel 103 may include two special-shaped defining structures 300 spaced apart with each other. For example, the special-shaped defining structure 300 is bent towards the light-emitting region 010 of the first color sub-pixel 101. For example, the special-shaped defining structure 300 is bent towards the light-emitting region 010 of the third color sub-pixel 103.

In some examples, as shown in Fig. 13 and Fig. 14, the first electrode 110 of each sub-pixel includes a main electrode 111 and a connecting electrode 112, and the shape of the main electrode 111 is similar to that of the light-emitting region 010 of the sub-pixel 10. The orthographic projection of the connecting electrode 112 on the base substrate 01 of at least one sub-pixel does not overlap with the orthographic projection of the defining structure 300 and the opening 201 on the base substrate 01.

For example, as shown in Fig. 13 and Fig. 14, in the direction perpendicular to the base substrate 01, the main electrode 111 overlaps with the first opening 210 of the pixel-defining pattern 200, and the connecting electrode 112 does not overlap with the first opening 210 of the pixel-defining pattern 200. For example, the connecting electrode 112 is configured to electrically connect with the light-emitting control transistor in the pixel circuit. For example, the first electrode 110 of the third color sub-pixel 103 further includes a shading portion 113 in addition to the main electrode 111 and the connecting electrode 112 to shade some structures in the pixel circuit.

For example, as shown in Fig. 13 and Fig. 14, the orthographic projection of the connecting electrode 112 of at least part of the sub-pixels 10 on the base substrate 01 does not overlap with the orthographic projections of the defining structure 300 and the opening 201 on the base substrate 01. For example, the orthographic projection of the connecting electrode 112 of each sub-pixel 10 on the base substrate 01 does not overlap with the orthographic projections of the defining structure 300 and the opening 201 on the base substrate 01. For example, the orthotropic projection of the connecting electrode 112 of at least one sub-pixel 10 on the base substrate 01 overlaps with the orthotropic projection of at least one of the defining structure 300 and the opening 201 on the base substrate 01. For example, the orthographic projection of the connecting electrode 112 of at least one sub-pixel 10 on the base substrate 01 overlaps with at least one of the orthographic projections of the defining structure 300 and the opening 201 on the base substrate 01, and the overlapping size does not exceed 1 micron.

For example, as shown in Fig. 13 and Fig. 14, the connecting electrode 112 is configured to be electrically connected to the light-emitting control transistor through a via located in the insulating layer between the connecting electrode and the light-emitting control transistor, and the defining structure 300 and the opening 201 do not overlap with the via in at least one sub-pixel 10 in the direction perpendicular to the base substrate. For example, in the direction perpendicular to the base substrate, the defining structure 300 and the opening 201 do not overlap with the via in each sub-pixel 10.

In the display substrate in the example shown in Fig. 13 and Fig. 14, except that the shape and position of the defining structure 300 and the second opening 220 are different from the shape and position of the defining structure 300 and the second opening 220 of the display substrate shown in Fig. 1 to Fig. 3, the other structures in the display substrate shown in Fig. 13 and Fig. 14 can have the same characteristics as the corresponding structures in the display substrate shown in Fig. 1 to Fig. 3, which will not be described again here. For example, the cross-section of the defining structure 300 shown in the display substrate shown in Fig. 10 can have the same characteristics as the cross-section of the defining structure 300 shown in the display substrate shown in Fig. 1 to Fig. 3, and will not be described again here.

For example, Fig. 13 and Fig. 14 schematically show that one sub-defining structure 330 is arranged between two adjacent sub-pixels 10, but is not limited thereto, and two sub-defining structures 330 may be arranged between the two adjacent sub-pixels 10. For example, Fig. 13 and Fig. 14 schematically show the spaced arrangement of the defining structure 300 with the first electrode 110, but is not limited thereto, and the defining structure 300 may also cover the edge of the first electrode 110. For example, Fig. 13 and Fig. 14 schematically show that the defining structure 300 is exposed by the second opening 220, but is not limited thereto, and the defining structure 300 can also be exposed by the first opening 210.

For example, as shown in Fig. 13, the length of at least one sub-defining structure 330 is L11, and the length of the second opening 220 overlapping with the sub-defining structure 330 is L12, and L11 is greater than L12, whereby the size of the second opening limits the degree to which the light-emitting functional layer of the sub-pixel is isolated. For example, the length of at least one sub-defining structure 330 is L10, and the length of the second opening 220 overlapping with the sub-defining structure 330 is L20, and L10 is basically equal to L20. Therefore, it is necessary to control the uniformity of the pixel-defining pattern and the defining structure at different positions in the display substrate to ensure the uniformity of the isolation effect of the light-emitting functional layer. The length of the sub-defining structure 330 may be the maximum size of the sub-defining structure 330 in the extension direction, and the length of the second opening 220 may be the maximum size of the second opening 220 in the extension direction of the sub-defining structure 330.

It should be noted that the cross-sectional drawings shown in Fig. 1 to Fig. 16 are only schematic. For example, the surface of the pixel-defining portion away from the base substrate can have a flat surface at some positions, and can be an arc-shaped surface at some positions, and the features such as the width, height and corners of the defining structure in each cross-sectional drawing, and features such as the width, height and corners of the pixel-defining portion are only schematic, and do not represent the specific size relationship and specific topography characteristics.

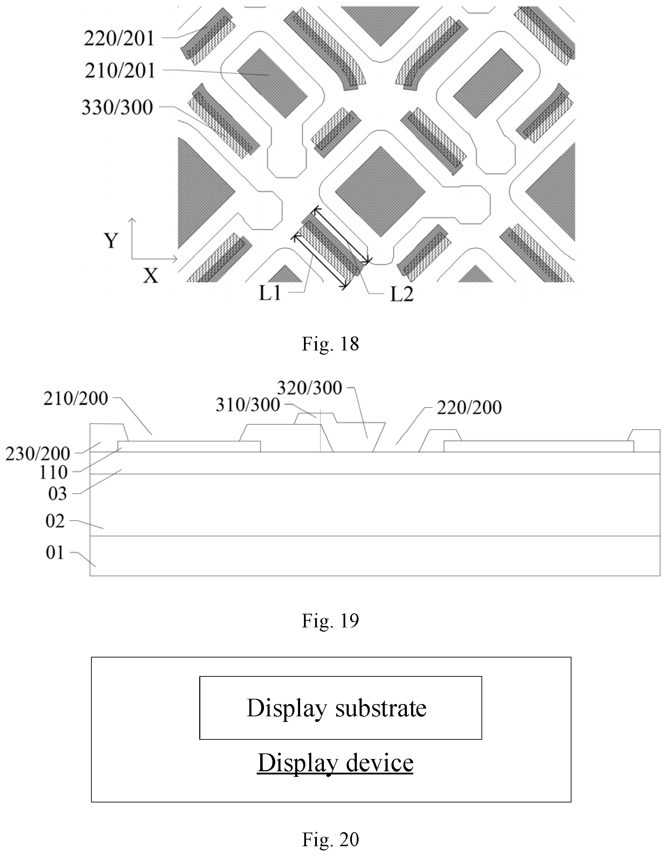

Fig. 17 is a schematic diagram of a partial planar structure of the display substrate provided according to another example of an embodiment of the present disclosure. Fig. 18 is a partial enlarged view of the display substrate shown in Fig. 17. The display substrate shown in Fig. 17 and Fig. 18 differs from the display substrate shown in Fig. 13 in the length relationship between the defining structure 300 and the second opening 220 overlapping with it. In the display substrate shown in Fig. 17 and Fig. 18, except the length relationship between the defining structure and the second opening overlapping with it, the other structures can have the same characteristics as the corresponding structure in the display substrate shown in Fig. 13, and will not be described again here.

For example, as shown in Fig. 17 and Fig. 18, in the extension direction of the sub-defining structure 300, the length of at least one sub-defining structure 330 is L1, and the length of the second opening 220 overlapping the sub-defining structure 330 is L2, and L1 is smaller than L2, so that one side edge of the sub-defining structure is completely exposed, and the length of the sub-defining structure determines the degree to which the light-emitting functional layer is isolated.

Fig. 19 is a schematic diagram of a partial cross-sectional structure of a display substrate provided according to another embodiment of the present disclosure.

As shown in Fig. 2 and Fig. 19, the display substrate includes a base substrate 01, a plurality of sub-pixels 10 and a pixel-defining pattern 200 located on the base substrate 01. Each sub-pixel 10 in at least part of the sub-pixels 10 includes a light-emitting functional layer 130, and the light-emitting functional layer 130 includes a plurality of film layers. The sub-pixel 10 further includes a first electrode 110 and a second electrode 120 located on both sides of the light-emitting functional layer 130 in a direction perpendicular to the base substrate 01 (for example, in a direction perpendicular to the direction of the XY plane as shown in Fig. 1), and the first electrode 110 is located between the light-emitting functional layer 130 and the base substrate 01. The light-emitting functional layer 130 may include a light-emitting layer for emitting light as well as a charge-generating layer 133. The pixel-defining pattern 200 includes a plurality of openings 210 and a plurality of second openings 220, the plurality of first openings 210 are configured to define light-emitting regions 010 of at least part of the sub-pixels 10, and at least part of at least one layer of the light-emitting functional layer 130 in the first opening 210 is a continuous part, and at least a part in at least one of the second openings is partially isolated. As schematically shown in Fig. 1 and Fig. 2, a part of the film layer of the light functional layer 130 in the first opening 210 is a continuous portion, and the part in the second opening 220 is isolated. One sub-pixel 10 corresponds to at least one first opening 210, at least part of the light-emitting functional layer 130 of the sub-pixel 10 is located in the first opening 210 corresponding to the sub-pixel 10, and the first opening 210 is configured to expose the first electrode 110.

As shown in Fig. 19, the display substrate further includes a defining structure 300 located on the base substrate 01, the defining structure 300 is located between at least two adjacent sub-pixels 10 of different colors, the defining structure 300 includes a first portion 310 covering a surface of the pixel-defining portion 230 away from the base substrate 01 and a second portion 320 located in the second opening 220, and the second portion 320 of the defining structure 300 is configured to isolate at least one layer of the light-emitting functional layer. For example, the first portion 310 of the defining structure 300 is located on a side of the pixel-defining portion 230 away from the base substrate 01, and the first portion 312 of the defining structure 300 overlaps the pixel-defining portion 230 in the direction perpendicular to the base substrate 01. For example, at least part of the second portion 320 of the defining structure 300 does not overlap with the pixel-defining portion 230 in the direction perpendicular to the base substrate 01. For example, at least part of the second portion 320 of the defining structure 300 covers at least part of the side of the pixel-defining portion 230. For example, the second portion 320 of the defining structure 300 does not overlap with a surface of the pixel-defining portion 230 away from the base substrate 01 in the direction perpendicular to the base substrate 01.

As shown in Fig. 19, the material of the defining structure 300 includes an organic material, and an edge of a surface of the second portion 320 of the defining structure 300 away from the base substrate 01 protrudes relative to an edge of a surface of the second portion 320 close to the base substrate 01. For example, an angle between a side of the second portion 320 of the defining structure 300 and a plane where a surface of the defining structure 300 close to the base substrate 01 is located is greater than 20 degrees and less than 90 degrees.

The first portion of the defining structure made of the organic material provided in the present disclosure covers the pixel-defining portion, and while the second portion falls into the second opening, the surface edge of the second portion of the defining structure away from the base substrate is set to protrude relative to the surface edge of the second portion close to the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structures on the processes and throughput.

In some examples, as shown in Fig. 19, an edge of a surface of the first portion 310 of the defining structure 300 close to the base substrate 01 protrudes from an edge of a surface of the first portion 310 of the defining structure 30 away from the base substrate 01, and the thickness of the first portion 310 of the defining structure 300 is less than the thickness at least part of the second portion 320 of the defining structure 300. For example, the thickness of the first portion 310 of the defining structure 300 is smaller than the thickness of the part of the second portion 320 of the defining structure 300 that does not overlap with the pixel-defining portion 230. For example, the thickness of the first portion 310 of the defining structure 300 is smaller than the thickness of the part of the second portion 320 of the defining structure 200 that overlaps the pixel-defining portion 230.

For example, as shown in Fig. 19, the thickness of the second portion 320 of the defining structure 300 is greater than that of the pixel-defining portion 230. For example, the thickness at each position of the second portion 320 of the defining structure 300 is greater than that of the pixel-defining portion 230. For example, the thickness of the first portion 310 of the defining structure 300 is smaller than the thickness of the pixel-defining portion 230.

For example, as shown in Fig. 19, the size of the defining structure 300 covering the pixel-defining portion 230 is not greater than 20 microns. For example, the size of the defining structure 300 covering the pixel-defining portion 230 is not greater than 15 microns, or not greater than 14 microns, or not greater than 13 microns, or not greater than 10 microns, or the like.

In the display substrate shown in Fig. 19, except that position relationship of the defining structure and the pixel-defining portion in the direction perpendicular to the base substrate is different, other structures, such as the shapes of the sub-pixels, of the first opening and of the second opening, and the size relationship between the defining structure and the second opening can have the same characteristics as the corresponding structures in the display substrate shown in Fig. 1 to Fig. 18, and will not be described again here.

Fig. 20 is a schematic block diagram of a display device provided according to another embodiment of the present disclosure. Another embodiment of the present disclosure provides a display device including any display substrate as mentioned above.

For example, the display device also includes a cover plate located on the light emitting side of the display substrate.

For example, the display device may be a display device such as an organic light-emitting diode display device and any product or component with a display function, such as a television, a digital camera, a mobile phone, a watch, a tablet computer, a laptop computer, a navigation instrument, or the like, which is not limited in the present embodiment.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate comprising:
a base substrate;
a plurality of sub-pixels located on the base substrate, wherein each sub-pixel in at least part of the sub-pixels comprises a light-emitting functional layer, and the light-emitting functional layer comprises a plurality of film layers;
a pixel-defining pattern located on the base substrate, wherein the pixel-defining pattern comprises a plurality of openings and a pixel-defining portion surrounding the plurality of openings, and at least part of at least one layer of the light-emitting functional layer is isolated in at least one of the openings;
a defining structure located between the pixel-defining portion and the base substrate,
wherein the defining structure is at least located between two adjacent sub-pixels of different colors, and the defining structure comprises a first portion covered by the pixel-defining portion and a second portion exposed by the opening, and the second portion of the defining structure is configured to isolate the at least one layer of the light-emitting functional layer;
a material of the defining structure comprises an organic material, and an orthographic projection of an edge of, a side surface of the second portion of the defining structure, away from the base substrate on the base substrate falls into an orthographic projection of the opening on the base substrate.

2. The display substrate according to claim 1, wherein the plurality of openings comprises a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one of the second openings is isolated;
the second portion of the defining structure is exposed by at least one kind of the first opening and the second opening.

3. The display substrate according to claim 1, wherein a thickness of the defining structure is not greater than 5 microns, and a surface edge of a side of the second portion of the defining structure away from the base substrate protrudes relative to a surface edge of a side of the second portion of the defining structure close to the base substrate by a size not greater than 5 microns.

4. The display substrate according to claim 1, wherein an angle between a side surface of the second portion of the defining structure and a plane where a first surface of the defining structure close to the base substrate is located is greater than 20 degrees and less than 90 degrees;
an orthographic projection of the first surface on the base substrate falls into an orthographic projection, of a second surface of the second portion away from the base substrate, on the base substrate, and a distance between an orthographic projection of an edge of the first surface and an orthographic projection of an edge of the second surface is not greater than 5 microns.

5. The display substrate according to claim 1, 3 or 4, wherein each sub-pixel in the at least part of the sub-pixels further comprises a first electrode and a second electrode located on both sides of the light-emitting functional layer, and the first electrode is located between the light-emitting functional layer and the base substrate;
a thickness of the defining structure is greater than that of the first electrode, and a thickness of at least part of the pixel-defining portion that does not overlap with the defining structure in a direction perpendicular to the base substrate is greater than the thickness of the defining structure.

6. The display substrate according to claim 5, wherein the defining structure covers an edge of the first electrode.

7. The display substrate according to claim 6, wherein the plurality of openings comprises a plurality of first openings, the plurality of first openings is configured to define light-emitting regions of the at least part of the sub-pixels, and at least part of the at least one layer of the light-emitting functional layer in the first opening is a continuous part, and the second portion of the defining structure is at least exposed by the first opening.

8. The display substrate according to claim 6, wherein the plurality of openings comprises a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated;
an orthographic projection of the defining structure on the base substrate does not overlap with an orthographic projection of the first opening on the base substrate, and the second opening exposes the second portion of the defining structure.

9. The display substrate according to any one of claims 6 to 8, wherein, a size of a part, of the defining structure, covering the first electrode is not greater than 5 microns in a direction of arrangement of the two adjacent sub-pixels of different colors.

10. The display substrate according to any one of claims 1 to 5, wherein each sub-pixel in the at least part of the sub-pixels further comprises a first electrode and a second electrode located on both sides of the light-emitting functional layer, and the first electrode is located between the light-emitting functional layer and the base substrate;
an insulating layer is disposed between the first electrode and the base substrate, both the first electrode and the defining structure are in contact with a surface of the insulating layer, the defining structure and the first electrode are spaced apart, and a distance between the defining structure and the first electrode which is closest to the defining structure is not greater than 10 microns.

11. The display substrate according to any one of claims 1 to 10, further comprising:
a photo spacer located at a side of the pixel-defining portion away from the base substrate,
wherein a material of the defining structure is different from a material of the photo spacer.

12. The display substrate according to claim 11, wherein a thickness of the photo spacer is not greater than 5 microns, and a thickness of the pixel-defining portion is not greater than 5 microns.

13. The display substrate according to claim 11 or 12, wherein an orthographic projection of the photo spacer on the base substrate overlaps with an orthographic projection of the defining structure on the base substrate; or an orthographic projection of the photo spacer on the base substrate does not overlap with an orthographic projection of the defining structure on the base substrate.

14. The display substrate according to claim 1, wherein a part of the defining structure between the two adjacent sub-pixels of different colors comprises at least one sub-defining structure.

15. The display substrate according to claim 14, wherein the adjacent two sub-pixels of different colors comprise a first color sub-pixel and a second color sub-pixel, the at least one sub-defining structure comprises one sub-defining structure, and an edge of a first portion of the sub-defining structure is closer to an edge of the light-emitting region of the first color sub-pixel.

16. The display substrate according to claim 15, wherein the first color sub-pixel comprises a red sub-pixel or a green sub-pixel, and the second color sub-pixel comprises a blue sub-pixel.

17. The display substrate according to claim 14, wherein the plurality of openings comprises a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated;
the at least one sub-defining structure comprises two sub-defining structures that are spaced apart from each other, a second portion of one of the two sub-defining structures is exposed by the first opening, and a second portion of the other of the two sub-defining structures is exposed by the second opening.

18. The display substrate according to claim 14, wherein the at least one sub-defining structure comprises two sub-defining structures that are spaced apart, and edges of the two sub-defining structures that are opposite to each other are exposed by the same opening.

19. The display substrate according to claim 14, wherein the plurality of openings comprises a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated;
the at least one sub-defining structure comprises one sub-defining structure, a side edge of the one sub-defining structure is exposed by the first opening, and another side edge of the one sub-defining structure is exposed by the second opening.

20. The display substrate according to claim 14, wherein the at least one sub-defining structure comprises an annular sub-defining structure surrounding the light-emitting region of at least one sub-pixel.

21. The display substrate according to claim 17, wherein the two sub-defining structures are respectively two annular sub-defining structures surrounding light-emitting regions of the two adjacent sub-pixels of different colors.

22. The display substrate according to claim 10, wherein the first electrode of each sub-pixel comprises a main electrode and a connecting electrode, and the main electrode overlaps with the light emitting region of the sub-pixel and has a similar shape;
an orthographic projection of the connecting electrode of at least one sub-pixel on the base substrate does not overlap with orthographic projections of the defining structure and the opening on the base substrate.

23. The display substrate according to claim 11 or 12, wherein the plurality of openings comprises a plurality of first openings and a plurality of second openings, the plurality of first openings is configured to define light-emitting regions of the at least part of the sub-pixels, and at least part of the at least one layer of the light-emitting functional layer in the first opening is a continuous part, and at least a part of the at least one layer of the light-emitting functional layer in at least one of the second openings is isolated;
the defining structure comprises a plurality of defining portions and a connecting portion connecting at least a part of the plurality of defining portions, in a direction perpendicular to the base substrate, the defining portion overlaps with the second opening, and an orthographic projection of the connecting portion on the base substrate completely falls into an orthographic projection of the pixel-defining portion on the base substrate; and
an orthographic projection of the photo spacer on the base substrate completely falls into an orthographic projection of the connecting portion on the base substrate.

24. The display substrate according to claim 2, wherein at least one second opening is shaped as a strip, and the at least one second opening is located between the two adjacent sub-pixels of different colors, and a long side of the strip is perpendicular to an arrangement direction of the two adjacent sub-pixels of different colors.

25. The display substrate according to claim 24, wherein the long edge of the strip is parallel to an edge of the first opening closest to the strip.

26. The display substrate according to claim 14, wherein, in an extension direction of the sub-defining structure, a length of the opening overlapping with the sub-defining structure is greater than or less than a length of the sub-defining structure.

27. A display substrate comprising:
a base substrate;
a plurality of sub-pixels located on the base substrate, wherein each sub-pixel in at least part of the sub-pixels comprises a light-emitting functional layer, and the light-emitting functional layer comprises a plurality of film layers;
a pixel-defining pattern located on the base substrate, the pixel-defining pattern comprises a plurality of first openings, a plurality of second openings and a pixel-defining portion surrounding the plurality of first openings and the plurality of second openings, the plurality of first openings is configured to define light-emitting regions of the at least part of the sub-pixels, and at least part of at least one layer of the light-emitting functional layer in the first opening is a continuous part, and at least a part of the at least one layer of the light-emitting functional layer in at least one of the second openings is isolated;
a defining structure located on the base substrate,
wherein the defining structure is at least located between two adjacent sub-pixels of different colors, and the defining structure comprises a first portion covering a surface of the pixel-defining portion away from the base substrate and a second portion located in the second opening, and the second portion of the defining structure is configured to isolate at least one layer of the light-emitting functional layer;
a material of the defining structure comprises an organic material, and a surface edge of a side of the second portion of the defining structure away from the base substrate protrudes relative to a surface edge of a side of the second portion of the defining structure close to the base substrate.

28. The display substrate according to claim 27, wherein a surface edge of a side of the first portion of the defining structure close to the base substrate protrudes from a surface edge of a side of the first portion of the defining structure away from the base substrate, and a thickness of the first portion is less than a thickness at least some positions of the second portion.

29. A display device, comprising the display substrate according to any one of claims 1 to 28.
